# FASCICULE DE BREVET EUROPEEN

(11) **EP 4 155 835 B1**
(45) Date de publication et mention de la délivrance du brevet: **08.04.2026**
(21) Numéro de dépôt: 22195766.5
(22) Date de dépôt: 15.09.2022
(51) Int. Cl.: G04F 10/00, H03M 3/00

(54) **CONVERTISSEUR TEMPS NUMÉRIQUE ET BOUCLE À VERROUILLAGE DE PHASE**
DIGITALER ZEITUMWANDLER UND PHASENREGELSCHLEIFE
DIGITAL TIME CONVERTER AND PHASE LOCKING LOOP

(30) Priorité: 24.09.2021 FR 2110080
(43) Date de publication de la demande: 29.03.2023
(73) Titulaire: Commissariat à l'Energie Atomique et aux Energies Alternatives, 75015 Paris (FR)
(72) Inventeur: LACHARTRE, David, 38054 GRENOBLE CEDEX 9 (FR)
(74) Mandataire: Cabinet Beaumont

(56) Documents cités:
- US-A1- 2017 194 972
- DAYANIK MEHMET BATUHAN ET AL: "A 28.5-33.5GHz fractional-N PLL using a 3rd order noise shaping time-to-digital converter with 176fs resolution", 2013 PROCEEDINGS OF THE ESSCIRC (ESSCIRC), IEEE, 14 September 2015 (2015-09-14), pages 376 - 379, XP032803411, ISSN: 1930-8833, ISBN: 978-1-4799-0643-7, [retrieved on 20151030], DOI: 10.1109/ESSCIRC.2015.7313906
- WANG ZIXUAN ET AL: "An ADPLL with a MASH 1-1-1 [Delta][Sigma] Time-digital c", MELECON 2014 - 2014 17TH IEEE MEDITERRANEAN ELECTROTECHNICAL CONFERENCE, IEEE, 13 April 2014 (2014-04-13), pages 266 - 270, XP032597874, DOI: 10.1109/MELCON.2014.6820544
- YING CAO ET AL: "1-1-1 MASH $\Delta \Sigma$ Time-to-Digital Converters With 6 ps Resolution and Third-Order Noise-Shaping", IEEE JOURNAL OF SOLID-STATE CIRCUITS, IEEE, USA, vol. 47, no. 9, 1 September 2012 (2012-09-01), pages 2093 - 2106, XP011457913, ISSN: 0018-9200, DOI: 10.1109/JSSC.2012.2199530
- REZVANYVARDOM M. ET AL: "A Novel Cyclic Time to Digital Converter Based on Triple-Slope Interpolation and Time Amplification", vol. 24, no. 3, 15 September 2015 (2015-09-15), CZ, pages 800 - 807, XP093019826, ISSN: 1210-2512, Retrieved from the Internet <URL:https://www.radioeng.cz/fulltexts/2015/15_03_0800_0807.pdf> DOI: 10.13164/re.2015.0800

## Description

### Domaine technique

La présente description concerne de façon générale les circuits électroniques, et plus particulièrement les convertisseurs d'une durée en un signal numérique représentatif de ladite durée, ou convertisseurs temps numérique, et les boucles à verrouillage de phase comprenant de tels convertisseurs temps numérique.

### Technique antérieure

Des convertisseurs temps numérique sont connus. Ces convertisseurs sont configurés pour convertir une durée en un signal numérique représentatif de la valeur de cette durée.

Par exemple, un convertisseur temps numérique connu comprend une succession d'étages formant une ligne à retard. L'état de chaque étage de la ligne à retard est échantillonné à chaque front actif d'un signal de cadencement du convertisseur. En outre, la ligne à retard reçoit en entrée un front d'un premier signal, qui se propage dans la ligne à retard. Au front actif suivant du signal de cadencement, l'état échantillonné de la ligne à retard est alors représentatif d'une durée séparant la fourniture du front du premier signal à la ligne à retard du front actif suivant du signal de cadencement. Un inconvénient d'un tel convertisseur temps numérique, appelé convertisseur temps numérique flash, est que la précision de mesure de la durée séparant le front du premier signal du front actif suivant du signal de cadencement est limitée par le temps de propagation d'un étage du convertisseur. Un tel convertisseur nécessite également une calibration du temps de propagation dans chaque étage du convertisseur, de sorte que chaque étage introduise le même retard. Par ailleurs, lorsqu'un tel convertisseur est mis en œuvre dans une boucle à verrouillage de phase en tout numérique (ADPLL de l'anglais "All Digital Phased-Locked Loop"), il est généralement nécessaire d'effectuer une normalisation de la sortie du convertisseur, ce qui implique des traitements supplémentaires non souhaitables.

US 2017/194972 A1 divulgue un convertisseur temps numérique basée sur un convertisseur de type Wilkinson.

DAYANIK MEHMET BATUHAN ET AL: "A 28.5-33.5GHz fractional-N PLL using a 3rd order noise shaping time-to-digital converter with 176fs resolution",2013 PROCEEDINGS OF THE ESSCIRC (ESSCIRC), IEEE, 14 septembre 2015 (2015-09-14), pages 376-379, concerne une boucle à verrouillage de phase numérique fractionnaire-N, basée sur un convertisseur à temps-numérique de type delta-sigma en temps continu.

### Résumé de l'invention

Il existe un besoin de pallier tout ou partie des inconvénients des convertisseurs temps numérique connus.

Par exemple, il existe un besoin de pallier tout ou partie des inconvénients des convertisseurs temps numérique connus destinés à une mise en œuvre dans une boucle à verrouillage de phase en tout numérique.

Par exemple, il existe un besoin d'un convertisseur temps numérique qui, lorsqu'il est mis en œuvre dans une boucle de phase en tout numérique, fournit une sortie sous la forme d'un écart de phase normalisé.

Par exemple, il existe un besoin d'un convertisseur temps numérique qui, lorsqu'il est mis en œuvre dans une boucle à verrouillage de phase en tout numérique, ne nécessite pas de signal d'horloge autre que les signaux d'horloge respectivement reçu et fourni par la boucle à verrouillage de phase.

Par exemple, il existe un besoin d'un convertisseur temps numérique qui soit simple et compact à mettre en œuvre.

Par exemple, il existe un besoin d'un convertisseur temps numérique qui, lorsqu'il est mis en œuvre dans une boucle à verrouillage de phase en tout numérique, tire parti du filtrage passe-bas mis en œuvre dans la boucle.

Par exemple, il existe un besoin d'un convertisseur temps numérique qui soit particulièrement adapté à une mise en œuvre dans une boucle à verrouillage de phase en tout numérique, et qui soit également utilisable dans tout autre application ou système électronique où une conversion temps numérique est requise.

Un mode de réalisation pallie tout ou partie des inconvénients des convertisseurs temps numérique connus, par exemple lorsqu'ils sont mis en œuvre dans une boucle à verrouillage de phase en tout numérique.

Un mode de réalisation prévoit un convertisseur temps numérique comprenant :
un premier circuit configuré pour fournir, à chaque front actif d'un premier signal, une première impulsion de durée déterminée par un écart entre ledit front actif du premier signal et un front actif immédiatement successif d'un deuxième signal ;
un circuit intégrateur configuré, à chaque première impulsion, pour intégrer :
   - la première impulsion,
   - une deuxième impulsion débutant après la première impulsion et en synchronisme avec un signal d'horloge, et
   - une troisième impulsion débutant après la deuxième impulsion et en synchronisme avec le signal d'horloge,
un deuxième circuit configuré pour générer, pour chaque première impulsion, la deuxième impulsion correspondante ;
un troisième circuit configuré pour quantifier sur un bit un signal de sortie du circuit intégrateur et, au début de chaque troisième impulsion, mémoriser sur un premier bit ladite quantification binaire ; et
un quatrième circuit configuré pour générer, pour chaque première impulsion, la troisième impulsion correspondante à partir du premier bit.

Selon un mode de réalisation, le deuxième circuit est configuré pour recevoir le signal d'horloge, et pour générer, au moins en partie à partir du signal d'horloge, au moins un troisième signal configuré pour commander les mémorisations par le troisième circuit et les générations des troisièmes impulsions par le quatrième circuit.

Selon un mode de réalisation, le premier circuit est configuré pour fournir un quatrième signal indiquant un début et une fin de chaque première impulsion, le deuxième circuit étant configuré pour recevoir le quatrième signal et pour générer le troisième signal à partir du signal d'horloge et du quatrième signal.

Selon un mode de réalisation les premier et deuxième circuits sont configurés pour que les deuxièmes impulsions placent un zéro de conversion du convertisseur au milieu de la dynamique du convertisseur.

Selon un mode de réalisation, le quatrième circuit est configuré pour que l'intégration de chaque troisième impulsion mette en oeuvre une soustraction de la quantification binaire mémorisée au début de ladite troisième impulsion.

Selon un mode de réalisation, les premier et deuxième circuits sont configurés pour que chaque deuxième impulsion provoque, sur le signal de sortie du circuit intégrateur, une variation d'amplitude identique et de signe opposé à une variation d'amplitude que provoquerait une première impulsion de durée déterminée par la moitié de la dynamique du convertisseur.

Le convertisseur est de type sigma-delta et le quatrième circuit est configuré pour que chaque troisième impulsion mette en œuvre une contre réaction négative sigma-delta.

Selon un mode de réalisation :
les premières, deuxièmes et troisièmes impulsions sont signées ;
les premier et deuxième circuits sont configurés pour qu'un signe des deuxièmes impulsions soit opposé à un signe des premières impulsions et qu'une durée maximale des premières impulsions que le convertisseur peut convertir multipliée par une amplitude des premières impulsions soit égale à deux fois une durée des deuxièmes impulsions multipliée par une amplitude des deuxièmes impulsions ; et
le quatrième circuit est configuré pour qu'un signe de chaque troisième impulsion soit déterminé par un état du premier bit et qu'une amplitude des troisièmes impulsions multipliée par une durée des troisièmes impulsion soit égale à la durée des deuxièmes impulsions multipliée par l'amplitude des deuxièmes impulsions.

Selon un mode de réalisation, les deuxièmes et troisièmes impulsions ont chacune une durée multiple d'une période du signal d'horloge, de préférence égale à une période du signal d'horloge.

Selon un mode de réalisation, une sortie dudit convertisseur est au moins en partie déterminée par le premier bit.

Selon un mode de réalisation, le convertisseur est du type sigma-delta à mise en forme du bruit à étage multiple, le convertisseur comprenant un premier étage comprenant le circuit intégrateur et les premier, deuxième, troisième et quatrième circuits, et un deuxième étage configuré pour recevoir un signal de sortie du circuit intégrateur du premier étage et pour fournir un signal numérique de sortie du deuxième étage à partir du signal de sortie du circuit intégrateur du premier étage, une sortie dudit convertisseur étant déterminée au moins en partie par le premier bit et le signal numérique de sortie du deuxième étage.

Selon un mode de réalisation, le deuxième étage est configuré pour :
générer, après chaque troisième impulsion, une quatrième impulsion débutant en synchronisme avec le signal d'horloge ;
intégrer, pendant chaque quatrième impulsion, une somme du signal de sortie du circuit intégrateur du premier étage et d'un signal de contre réaction, quantifier sur un bit un résultat de ladite intégration et mémoriser sur un deuxième bit ladite quantification binaire à la fin de la quatrième impulsion ;
générer, pendant chaque troisième impulsion, une cinquième impulsion à partir du deuxième bit, et le signal de contre réaction en intégrant ladite cinquième impulsion ; et
mémoriser le deuxième bit sur un troisième bit à chaque front actif du premier signal, le signal numérique de sortie du deuxième étage étant généré à partir des deuxième et troisième bits ou correspondant aux deuxième et troisième bits.

Selon un mode de réalisation, le deuxième étage comprend :
un cinquième circuit configuré pour générer, après chaque troisième impulsion, une quatrième impulsion débutant en synchronisme avec le signal d'horloge ;
un circuit intégrateur configuré pour intégrer, pendant chaque quatrième impulsion, une somme du signal de sortie du circuit intégrateur du premier étage et d'un signal de contre réaction ;
un sixième circuit configuré pour quantifier sur un bit une sortie du circuit intégrateur du deuxième étage et mémoriser ladite quantification binaire sur un deuxième bit, à la fin de chaque quatrième impulsion ;
un septième circuit configuré, à chaque troisième impulsion, pour fournir ledit signal de contre réaction en intégrant, pendant ladite troisième impulsion, une cinquième impulsion déterminée à partir du deuxième bit ; et
un circuit configuré pour mémoriser le deuxième bit sur un troisième bit à chaque front actif du premier signal, le signal numérique de sortie du deuxième étage étant généré à partir des deuxième et troisième bits ou correspondant aux deuxième et troisième bits.

Selon un mode de réalisation, le convertisseur comprend une première entrée configurée pour recevoir le premier signal et une deuxième entrée configurée pour recevoir le signal d'horloge, et :
- le deuxième signal et le signal d'horloge sont confondus, ou
- le convertisseur comprend un circuit diviseur de fréquence, de préférence par deux, configuré pour recevoir le signal d'horloge et pour fournir le deuxième signal.

Un autre mode de réalisation prévoit une boucle à verrouillage de phase en tout numérique configurée pour recevoir un signal à une première fréquence et pour fournir un signal à une deuxième fréquence égale à N/D fois la première fréquence, avec N et D deux valeurs positives, la boucle à verrouillage de phase comprenant un convertisseur tel que décrit ci-dessus, la première entrée du convertisseur étant configurée pour recevoir le signal à la première fréquence et la deuxième entrée du convertisseur étant configurée pour recevoir le signal à la deuxième fréquence.

Selon un mode de réalisation, la boucle à verrouillage de phase comprend
un circuit configuré pour fournir un premier signal numérique incrémenté de la valeur N à la première fréquence ;
un circuit configuré pour fournir un deuxième signal numérique incrémenté de la valeur D à la deuxième fréquence et un troisième signal numérique correspondant à une mémorisation du deuxième signal numérique cadencée à la première fréquence ;
un filtre numérique configuré pour recevoir une soustraction d'une sortie du convertisseur et du troisième signal numérique au premier signal numérique et pour commander un oscillateur configuré pour fournir le signal à la deuxième fréquence, dans laquelle le deuxième signal du convertisseur est confondu avec le signal à la deuxième fréquence.

Selon un mode de réalisation, la boucle à verrouillage de phase comprend :
soit un circuit configuré pour fournir un premier signal numérique incrémenté de la valeur N à la première fréquence, et un circuit configuré pour fournir un deuxième signal numérique incrémenté de la valeur D/2 à la deuxième fréquence, avec D pair, soit un circuit configuré pour fournir un premier signal numérique incrémenté de la valeur 2N à la première fréquence et un circuit configuré pour fournir un deuxième signal numérique incrémenté de la valeur D à la deuxième fréquence ;
un circuit configuré pour fournir un troisième signal numérique correspondant à une mémorisation du deuxième signal numérique cadencée par le deuxième signal du convertisseur ;
un filtre numérique configuré pour recevoir une soustraction d'une sortie du convertisseur et du troisième signal numérique au premier signal numérique et pour commander un oscillateur configuré pour fournir le signal à la deuxième fréquence,
le deuxième signal du convertisseur étant obtenu en divisant par deux la fréquence du signal à la deuxième fréquence.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière très schématique et sous la forme de blocs fonctionnels, un mode de réalisation d'un convertisseur temps numérique ;
la figure 2 représente, de manière schématique, des détails d'un exemple de mode de réalisation du convertisseur temps numérique de la figure 1 ;
la figure 3 illustre, par des chronogrammes, le fonctionnement du convertisseur de la figure 2 ;
la figure 4 représente, de manière schématique et sous la forme de blocs, un mode de réalisation d'une boucle à verrouillage de phase en tout numérique ;
la figure 5 représente, de manière schématique, des détails d'un exemple de mode de réalisation du convertisseur temps numérique de la figure 1, dans un cas où le convertisseur est mis en œuvre dans une boucle à verrouillage de phase du type de celle de la figure 4 ;
la figure 6 illustre, par des chronogrammes, le fonctionnement du convertisseur de la figure 5 ;
la figure 7 représente, de manière schématique, des détails d'un autre exemple de mode de réalisation du convertisseur temps numérique de la figure 1, dans un cas où le convertisseur est mis en œuvre dans une boucle à verrouillage de phase du type de celle de la figure 4 ;
la figure 8 illustre, par des chronogrammes, le fonctionnement du convertisseur de la figure 7 ;
la figure 9 illustre une variante de réalisation du convertisseur de la figure 1 ;
la figure 10 illustre un exemple de mise en œuvre d'une partie du convertisseur des figures précédentes ;
la figure 11 illustre un exemple de mise en œuvre d'une autre partie du convertisseur des figures précédentes ;
la figure 12 illustre un exemple de mise en œuvre d'encore une autre partie du convertisseur des figures précédentes ;
la figure 13 illustre un exemple de mise en œuvre d'encore une autre partie du convertisseur des figures précédentes ; et
la figure 14 illustre un mode de réalisation détaillé de la variante de réalisation de la figure 9.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Dans la présente demande, sauf indication contraire on appelle "impulsion", par exemple, une variation en forme de créneau du niveau d'un signal par rapport à un état initial ou de repos, aussi appelé niveau zéro, du signal. Sauf indication contraire, on appelle "amplitude d'une impulsion", par exemple, la valeur absolue du niveau du signal pendant l'impulsion par rapport à son niveau zéro, c'est-à-dire la valeur absolue du niveau de l'impulsion, étant entendu qu'une impulsion peut avoir un niveau négatif ou positif par rapport au zéro du signal. Une impulsion avec un niveau négatif sera dite "impulsion négative" et une impulsion avec un niveau positif sera dite "impulsion positive". Par exemple, une impulsion négative d'amplitude A correspond à une impulsion de niveau égal à -A et une impulsion positive d'amplitude A correspond à une impulsion de niveau égal à +A.

Sauf indication contraire, on appelle "dynamique" d'un convertisseur temps-numérique, par exemple, la différence entre la plus grande valeur et la plus petite valeur que peut mesurer le convertisseur.

Il est ici proposé un convertisseur temps numérique de type sigma-delta pour mesurer une durée entre chaque front actif d'un premier signal et un front actif d'un deuxième signal suivant le front actif du premier signal.

Selon un mode de réalisation, à chaque front actif du premier signal, le convertisseur est configuré pour intégrer successivement, avec un circuit intégrateur, une première impulsion représentative de la durée à mesurer, une deuxième impulsion configurée pour centrer une dynamique de sortie du circuit intégrateur, et une troisième impulsion configurée pour mettre en œuvre la contre réaction négative de la boucle sigma-delta, le convertisseur étant en outre configuré pour quantifier et mémoriser sur un bit une sortie du circuit intégrateur, par exemple, au début de chaque troisième impulsion.

Dit autrement, chaque deuxième impulsion est configurée pour provoquer une variation du signal de sortie de l'intégrateur d'amplitude identique et de signe opposé à une variation du signal de sortie de l'intégrateur provoquée par une première impulsion correspondant à une durée à mesurer égale à la moitié de la dynamique du convertisseur. Dit encore autrement, les deuxièmes impulsions sont configurées pour placer le zéro de conversion du convertisseur au milieu de la dynamique du convertisseur.

Par exemple, le convertisseur est configuré pour qu'un signe des premières impulsions soit opposé à celui des deuxièmes impulsions et pour qu'une durée maximale des premières impulsions que le convertisseur peut convertir multipliée par une amplitude des premières impulsions soit égal à deux fois une durée des deuxièmes impulsions multipliée par une amplitude des deuxièmes impulsions.

Par ailleurs, dit autrement, chaque troisième impulsion est par exemple configurée pour soustraire en entrée du circuit intégrateur le résultat mémorisé de la quantification de la sortie du circuit intégrateur réalisée au début de la troisième impulsion, de sorte qu'après l'intégration de la troisième impulsion, la sortie du circuit intégrateur ne comprenne plus que l'erreur de quantification résiduelle.

Par exemple, le convertisseur est configuré pour que le signe de chaque troisième impulsion soit déterminé par l'état du bit correspondant à la mémorisation de la quantification de la sortie du circuit intégrateur, et pour qu'une amplitude des troisièmes impulsions multipliée par une durée des troisièmes impulsions soit égal à l'amplitude des deuxièmes impulsions multipliée par la durée des deuxièmes impulsions.

Dit encore autrement, il est ici proposé un convertisseur temps numérique de type sigma-delta fonctionnant, à chaque cycle de conversion, selon au moins trois phases comprenant successivement une première phase pendant laquelle la durée à convertir est intégrée, une deuxième phase pendant laquelle un zéro de conversion est centré au milieu de la dynamique du convertisseur, et une troisième phase pendant laquelle la contre réaction négative sigma-delta est mise en œuvre.

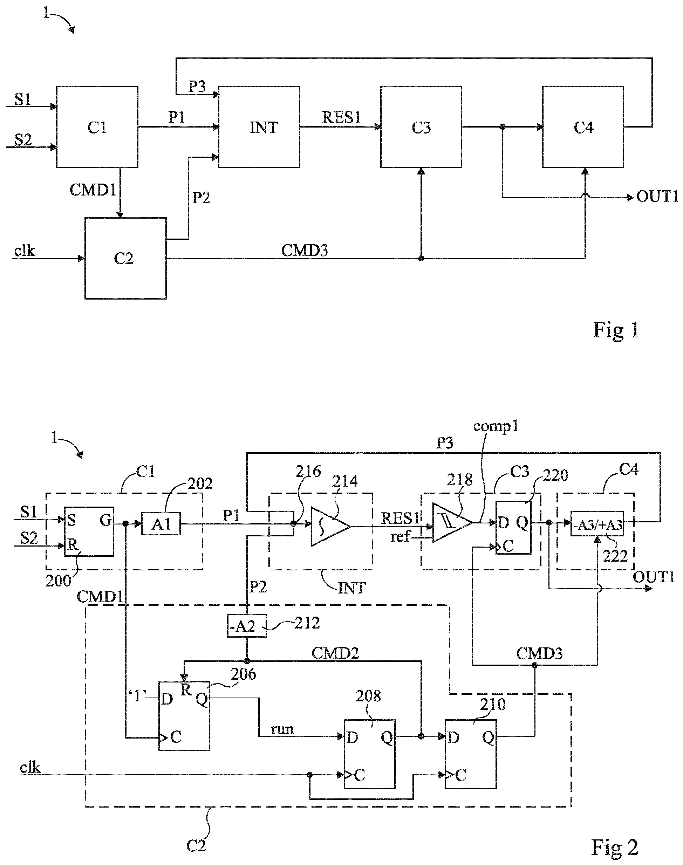

La figure 1 représente, de manière très schématique et sous la forme de blocs fonctionnels, un mode de réalisation d'un convertisseur temps numérique 1 de type sigma-delta.

Le convertisseur 1 comprend un premier circuit C1. Le circuit C1 est configuré pour fournir, à chaque front actif, par exemple à chaque front montant, d'un signal S1, une impulsion P1. La durée de l'impulsion P1 est déterminée par un écart entre le front actif du signal S1 et un front actif, par exemple un front montant, immédiatement successif d'un signal S2. Dit autrement, le circuit C1 est configuré pour fournir, à chaque front actif du signal S1, une impulsion P1 ayant une durée représentative du temps séparant ce front du signal S1 du front actif suivant du signal S2. Chaque impulsion P1 est, par exemple, une impulsion débutant lors d'un front actif du signal S1 et se terminant au front actif immédiatement suivant du signal S2.

Dans la suite de la description, on appelle Dmax la durée maximale des impulsions P1 que le convertisseur peut convertir. A titre d'exemple, une impulsion P1 ayant une durée Dmax correspond à une durée à mesurer égale à la durée maximale que peut mesurer le convertisseur, c'est-à-dire à l'écart maximal entre un front actif du signal S1 et un front actif suivant du signal S2 que peut mesurer le convertisseur.

Dans la suite de la description, on considère à titre d'exemple que les impulsions P1 ont toutes une durée inférieure ou égale à Dmax, ou, dit autrement, que les durées à mesurer avec le convertisseur 1 sont toutes comprises dans la dynamique du convertisseur.

Selon un mode de réalisation, le convertisseur 1 est configuré pour convertir la durée entre chaque front actif du signal S1 et un front actif immédiatement successif du signal S2 en un signal numérique de sortie du convertisseur 1.

A titre d'exemple, le circuit C1 est configuré pour recevoir les signaux S1 et S2 et pour fournir les impulsions P1.

Selon un mode de réalisation, à chaque front actif du signal S1, le circuit C1 est configuré pour générer un signal ou impulsion CMD1. La durée de l'impulsion CMD1 est déterminée par la durée entre le front du signal S1 et le front immédiatement successif du signal S2. La durée de l'impulsion CMD1 détermine la durée de l'impulsion P1, ou, dit autrement, l'impulsion P1 est déterminée à partir de l'impulsion CMD1. Dit autrement, chaque impulsion CMD1 indique le début d'une impulsion P1 correspondante et de la fin de cette impulsion P1. Chaque impulsion CMD1 est, par exemple, une impulsion débutant lors d'un front actif du signal S1 et se terminant au front actif immédiatement suivant du signal S2. Chaque impulsion P1 est, par exemple, une impulsion débutant en même temps qu'une impulsion CMD1 correspondante, et se terminant en même temps que cette impulsion CMD1.

A titre d'exemple, le circuit C1 comprend une bascule ("flip-flop" en anglais), non représentée en figure 1, recevant les signaux S1 et S2 sur deux de ses entrées et fournissant les impulsions CMD1. De préférence, la bascule est une bascule RS dont une entrée d'initialisation, c'est-à-dire l'entrée S de la bascule, est configurée pour recevoir le signal S1, dont l'entrée de remise à zéro, c'est-à-dire l'entrée R de la bascule, est configurée pour recevoir le signal S2, et dont une sortie, par exemple la sortie Q de la bascule, est configurée pour fournir le signal CMD1. De préférence, l'entrée S, respectivement R, de la bascule est sensible aux fronts actifs du signal S1, respectivement S2. Bien entendu, la personne du métier est en mesure de remplacer cette bascule par tout autre circuit permettant de générer, à partir des signaux S1 et S2, les impulsions CMD1. Par exemple, la personne du métier est en mesure de remplacer la bascule RS du circuit C1 par une bascule de type D, ou par un circuit autre qu'une bascule.

Le convertisseur 1 comprend en outre un circuit intégrateur INT. Le circuit INT est configuré pour intégrer des impulsions qu'il reçoit, et pour fournir un signal de sortie RES1 correspondant au résultat de cette intégration. Plus particulièrement, à chaque première impulsion P1, le circuit INT est configuré pour intégrer l'impulsion P1, puis une impulsion P2 correspondant, ou associée, à cette impulsion P1, puis une impulsion P3 correspondant, ou associée, à cette impulsion P1.

Pour chaque impulsion P1, l'impulsion P2 associée débute après l'impulsion P1, en synchronisme avec un signal d'horloge clk, et l'impulsion P3 associée débute après l'impulsion P2, également en synchronisme avec le signal clk. A titre d'exemple, les impulsions P2 et P3 débutent en synchronisme avec les fronts montants du signal clk. Selon un autre exemple, les impulsions P2 et P3 débutent en synchronisme avec les fronts descendants du signal clk. Selon un mode de réalisation, les impulsions P2 et P3 ont chacune des durées multiples, de préférence entières, d'une période du signal clk, par exemple des durées égales à une période du signal clk.

Selon un mode de réalisation, la fréquence du signal clk est suffisamment grande pour que la conversion par le convertisseur d'une durée déclenchée par un front actif du signal S1 soit terminée avant le début de la conversion suivante provoquée par le front suivant du signal S1. Par exemple, un facteur multiplicatif entre la fréquence du signal clk et celle du signal S1 est déterminé de sorte que, suite à chaque front actif du signal S1, le convertisseur 1 effectue une mise à jour de sa sortie avant qu'un nouveau front actif du signal S1 ne se produise. La détermination de ce facteur multiplicatif est à la portée de la personne du métier.

Un circuit C2 du convertisseur 1 est configuré pour générer, pour chaque impulsion P1, l'impulsion P2 correspondante. A titre d'exemple, le circuit C2 est configuré pour recevoir les signaux clk et CMD1, et pour fournir les impulsions P2 correspondantes. A titre d'exemple, le circuit C2 est configuré pour générer les impulsions P2 à partir des signaux clk et CMD1.

Le circuit C2 est configuré pour que les impulsions P2 centrent une dynamique de sortie de l'intégrateur INT. Dit autrement, les circuits C2 et C1 sont configurés pour que chaque impulsion P2 provoque une variation du signal RES1 d'amplitude identique et de signe opposé à une variation du signal RES1 provoquée par une impulsion P1 correspondant à une durée à mesurer égale à la moitié de la dynamique du convertisseur. Dit encore autrement, les circuits C2 et C1 sont configurés pour que les deuxièmes impulsions placent le zéro de conversion du convertisseur au milieu de la dynamique du convertisseur, c'est-à-dire pour que les deuxièmes impulsions P2 produisent, lors de leurs intégrations par le circuit INT, un décalage ou biais qui place le zéro de la dynamique de conversion au milieu de la durée maximale que le convertisseur 1 peut mesurer.

On appelle A1 l'amplitude des impulsions P1, A2 l'amplitude de impulsions P2 et K2*Tclk la durée des impulsions P2, avec A1 et A2 des valeurs réelles strictement positives, K2 un nombre entier positif et non nul, et Tclk la durée d'une période du signal clk.

Selon un mode de réalisation, les impulsions P1 et P2 sont signées. Les circuits C1 et C2 sont alors configurés pour que les impulsions P1 et P2 soient de signe opposé et que le produit de la durée maximale Dmax des impulsions P1 par l'amplitude A1 des impulsions P1 soit égal au double du produit de la durée K2*Tclk des impulsions P2 par l'amplitude A2 des impulsions P2. Dit autrement, les circuits C1 et C2 sont configurés pour les impulsions P1 et P2 soient de signe opposé et que Dmax*A1 = 2*K2*Tclk*A2. A titre d'exemple, les impulsions P1 sont positives et ont donc chacune un niveau égal à A1 et les impulsions P2 sont négatives et ont donc chacune un niveau égal à -A2. A titre d'exemple, lorsque A1 = 2*A2 et que K2 = 1, alors la durée Dmax des impulsions P1 est égale à Tclk. Dans un tel exemple, si chaque impulsion P1 débute lors d'un front actif du signal S1 et se termine lors du front actif suivant du signal S2, alors la durée maximale que le convertisseur peut mesurer entre chaque front actif du signal S1 et le front actif suivant du signal S2 est égale à Dmax.

La présente description ne se limite pas à l'exemple ci-dessus, et la personne du métier est en mesure de prévoir d'autres valeurs de K2, A1 et A2 permettant le fonctionnement décrit ci-dessus.

Un circuit C3 du convertisseur 1 est configuré pour quantifier sur un bit le signal RES1 de sortie du circuit intégrateur INT, et pour mémoriser, au début de chaque impulsion P3, cette quantification binaire du signal RES1 sur un bit OUT1.

Selon un mode de réalisation, le circuit C3 est configuré pour fournir un bit comp1 correspondant à la quantification binaire du signal RES1, et pour mettre à jour le bit OUT1 à partir du bit comp1 au début de chaque impulsion P3. Plus particulièrement, le circuit C3 est configuré pour comparer le signal RES1 à un niveau ref, de préférence égal à la moitié de la dynamique de sortie du circuit INT, et pour fournir le bit comp1 à un premier état binaire lorsque le signal RES1 est supérieur au niveau de référence ref, et à un deuxième état binaire lorsque le signal RES1 est inférieur au niveau de référence ref. Par exemple, le premier état binaire du signal comp1 correspond à niveau haut du signal comp1, et le deuxième état binaire du signal comp1 correspond à un niveau bas du signal comp1. A titre d'exemple, le niveau ou potentiel ref est égal à la moitié de la différence entre un potentiel d'alimentation haut Vdd et un potentiel d'alimentation bas, par exemple la masse ou Vss=-Vdd, du convertisseur 1.

Selon un mode de réalisation, les mémorisations mises en œuvre par le circuit C3, c'est-à-dire les mises à jour de l'état du bit OUT1 de sortie du circuit C3, sont commandées par un signal, ou des impulsions, CMD3. Le signal CMD3 présente des fronts actifs synchronisés, ou confondus, avec les débuts des impulsions P3. Par exemple, chaque impulsion P3 débute en même temps qu'un front actif du signal CMD3, ou, dit autrement, en même temps qu'une impulsion CMD3. De préférence, les durées des impulsions CMD3 et des impulsions P3 sont égales. A titre d'exemple, les impulsions P3 sont déterminées à partir du signal CMD3, ou, dit autrement, le signal CMD3 commande la génération ou fourniture des impulsions P3. A titre d'exemple, le circuit C3 comprend une bascule, par exemple de type D, qui échantillonne le résultat de la quantification binaire comp1 du signal RES1 par rapport au niveau ref à chaque début d'une impulsion P3, par exemple à chaque début d'une impulsion CMD3, et qui fournit en sortie le bit OUT1.

Selon un mode de réalisation, le circuit C2 est configuré pour fournir le signal CMD3. Selon un mode de réalisation, le circuit C2 est configuré pour fournir le signal CMD3 au moins en partie à partir du signal clk. Selon un mode de réalisation, le circuit C2 est configuré pour fournir le signal CMD3 à partir du signal clk et du signal CMD1.

Un circuit C4 du convertisseur 1 est configuré pour générer, pour chaque impulsion P1, l'impulsion P3 correspondante à partir du bit OUT1.

Selon un mode de réalisation, le circuit C4 est configuré pour que l'intégration de chaque impulsion P3 mette en œuvre une soustraction de la quantification binaire mémorisée au début de cette troisième impulsion P3. Dit de manière plus détaillée, le circuit C4 est configuré pour que, pour chaque impulsion P1, l'intégration de l'impulsion P3 associée par le circuit INT corresponde à une soustraction, sur le signal RES1, de la quantification binaire mémorisée au début de l'impulsion P3 par le circuit C3. Dit encore autrement, le circuit C4 est configuré pour que chaque impulsion P3 mette en œuvre la contre réaction négative sigma-delta, c'est-à-dire la contre réaction négative de type sigma-delta mise en œuvre dans le convertisseur 1.

Selon un mode de réalisation, le circuit C4 est configuré pour générer les impulsions P3 à partir du bit OUT1 et du signal CMD3. Dit autrement, la fourniture des impulsions P3 est commandée par le signal CMD3.

Selon un mode de réalisation, les impulsions P3 sont signées comme les impulsions P1 et P2. Le signe de chaque impulsion P3 est alors déterminé par la valeur (ou état) du bit OUT2. A titre d'exemple, lorsque le bit OUT2 est à un premier état binaire, l'impulsion P3 a alors un niveau négatif égal à -A3, et, lorsque le bit OUT2 est à un deuxième état binaire, l'impulsion P3 a alors un niveau positif égal à +A3. A3 est une valeur réelle strictement positive correspondant à l'amplitude de chaque impulsion P3 et étant identique pour toutes les impulsions P3. Du fait que chaque impulsion P3 a une amplitude égale à A3, le signal P3 a une amplitude crête à crête égale à 2*A3.

On appelle K3*Tclk la durée des impulsions P3, avec K3 un nombre entier positif et non nul. Selon un mode de réalisation, le circuit C4 est configuré pour que le produit de la durée K3*Tclk des impulsions P3 par l'amplitude A3 des impulsions P3 soit égal au produit de la durée K2*Tclk des impulsions P2 par l'amplitude A2 des impulsions P2. Dit autrement, le circuit C4 est configuré pour que K3*A3 = K2*A2.

Le convertisseur 1 décrit ci-dessus est particulièrement simple et compact à mettre en œuvre.

En outre, le convertisseur 1 ne nécessite pas de phase de calibration contrairement à de nombreux convertisseurs temps numérique connus.

Dans le convertisseur 1 de type sigma-delta, la quantification est mise en œuvre sur un seul bit. Il en résulte une meilleure linéarité de conversion que si la quantification avait été mise en œuvre sur plusieurs bits. Bien qu'une quantification sur un seul bit génère une grande erreur de quantification sous la forme d'un fort bruit de quantification, le convertisseur 1 est de type sigma-delta et possède donc la propriété de déplacer ce bruit de quantification vers les hautes fréquences, de telle manière que la densité de bruit à basse fréquence va être diminuée tandis que la densité de bruit à haute fréquence va être augmentée. Ainsi, en appliquant un filtrage passe-bas numérique à la sortie du convertisseur 1, une grande partie du bruit de quantification, par exemple plus de 99% du bruit de quantification, est supprimée et le rapport signal sur bruit du signal utile est amélioré, par exemple de 40 dB. Dans l'exemple illustré en figure 1, le signal OUT1 correspond au signal de sortie du convertisseur. La mise en œuvre d'un filtrage passe-bas numérique, par exemple cadencé par la fréquence du signal S1, de ce signal de sortie OUT1 fournit alors un mot binaire indiquant la valeur de la durée mesurée avec moins de bruit de quantification que le bit OUT1.

Selon un mode de réalisation dans lequel le convertisseur 1 est mis en œuvre dans une boucle à verrouillage de phase en tout numérique, le filtrage numérique passe-bas du signal OUT1 est mis en œuvre par le filtre numérique de la boucle à verrouillage de phase, étant entendu que le signal de sortie du convertisseur 1 peut être combiné à d'autres signaux numériques avant d'être fourni au filtre. Dans un tel mode de réalisation, le convertisseur 1 tire parti du filtre numérique passe-bas déjà présent dans la boucle à verrouillage de phase en tout numérique.

Selon un mode de réalisation dans lequel le convertisseur 1 est mis en œuvre dans une boucle à verrouillage de phase en tout numérique, le signal clk correspond au signal périodique de sortie de la boucle à verrouillage de phase, le signal S1 correspond au signal périodique d'entrée de la boucle à verrouillage de phase, et le signal S2 est obtenu à partir du signal clk. Ainsi, le convertisseur ne nécessite pas d'autres signaux d'horloge ou de cadencement que ceux disponibles en entrée et en sortie de la boucle à verrouillage de phase.

Selon un mode de réalisation dans lequel le convertisseur 1 est mis en œuvre dans une boucle à verrouillage de phase en tout numérique, le convertisseur 1 fournit directement un écart de phase normalisé, sans nécessiter de calcul supplémentaire.

La figure 2 représente, de manière schématique, des détails d'un exemple de mode de réalisation du convertisseur 1 de la figure 1.

Dans cet exemple, les fronts actifs des signaux S1 et S2 sont les fronts montants de ces signaux, étant entendu que la personne du métier est en mesure d'adapter la description faite ci-dessous au cas où les fronts actifs de l'un et/ou l'autre des signaux S1 et S2 sont des fronts descendants.

En outre, dans cet exemple, le niveau des impulsions P1 est égal à +A1, le niveau des impulsions P2 est égal à - A2, et K2 et K3 sont égaux chacun à 1. Ainsi, l'amplitude A3 des impulsions P3 est égale à l'amplitude A2 des impulsions P2, et, en outre, Dmax = 2*A2/A1*Tclk.

Dans l'exemple de la figure 2, le circuit C1 comprend une bascule 200. La bascule 200 est configurée pour qu'un front montant du signal S1 provoque la mise à l'état haut du signal CMD1 et que le front suivant du signal S2 provoque la remise à l'état bas du signal CMD1. Dit autrement, la bascule 200 est configurée pour qu'un front montant du signal S1 provoque le début d'une impulsion CMD1 correspondante et que le front suivant du signal S2 provoque la fin de cette impulsion CMD1. A titre d'exemple, la bascule 200 est une bascule de type RS ("RS flip-flop" en anglais) ayant une entrée S (entrée d'initialisation) recevant le signal S1, une entrée R (entrée de remise à zéro) recevant le signal S2 et une sortie Q fournissant les impulsions CMD1.

Dans l'exemple de la figure 2, le circuit C1 comprend également un circuit 202 (bloc "A1" en figure 2). Le circuit 202 est configuré pour recevoir les impulsions CMD1 et fournir les impulsions P1 correspondantes. Dit autrement, le circuit C1 est configuré pour fournir les impulsions P1 d'amplitude A1 à partir du signal CMD1. A titre d'exemple, le circuit 202 comprend un ou plusieurs éléments résistifs et/ou un interrupteur commandé par le signal CMD1.

Dans l'exemple de la figure 2, le circuit C2 est configuré pour générer, après chaque impulsion CMD1, une impulsion P2 débutant en même temps qu'un front actif, par exemple montant, du signal clk, et pour générer, après chaque impulsion P2, une impulsion CMD3 débutant en même temps qu'un front actif, par exemple montant, du signal clk. Le circuit C2 est configuré pour que la durée de chacune des impulsions P2 soit égale à K2*Tclk et que la durée de chacune des impulsions CMD3 soit égale à K3*Tclk, avec K2 et K3 égaux chacun à 1 dans cet exemple.

A titre d'exemple, comme cela est illustré en figure 2, le circuit C2 comprend trois bascules 206, 208 et 210. La bascule 206 est configurée pour fournir, à partir du signal CMD1, un signal run indiquant pour chaque impulsion CMD1 si l'impulsion est terminée ou non. La bascule 208 est configurée pour fournir un signal CMD2 déterminant le début et la fin de chaque impulsion P2 à partir du signal run et du signal clk. La bascule 210 est configurée pour fournir le signal CMD3 à partir du signal CMD2 et du signal clk. Le circuit C2 comprend en outre un circuit 212 (bloc "-A2") configuré pour fournir les impulsions P2 à partir du signal CMD2, chaque impulsion P2 ayant une amplitude A2.

A titre d'exemple, la bascule 206 est une bascule de type D ("D flip-flop" en anglais) ayant une entrée de donnée D recevant un niveau haut ('1' en figure 2), par exemple le potentiel d'alimentation Vdd du convertisseur 1, une entrée d'horloge (ou de synchronisation) C active sur front descendant et recevant le signal CMD1, une entrée de remise à zéro R active sur niveau haut et recevant le signal CMD2 et une sortie Q fournissant le signal run.

A titre d'exemple, la bascule 208 est une bascule de type D ("D flip-flop" en anglais) ayant une entrée de donnée D recevant le signal run, une entrée d'horloge C recevant le signal clk et étant sensible, ou active, sur les fronts actifs du signal clk, et une sortie Q fournissant le signal CMD2.

A titre d'exemple, la bascule 210 est une bascule de type D ("D flip-flop" en anglais) ayant une entrée de donnée D recevant le signal CMD2, une entrée d'horloge C recevant le signal clk et étant sensible, ou active, sur les fronts actifs du signal clk, et une sortie Q fournissant le signal CMD3.

Le circuit 212 est configuré pour recevoir les impulsions CMD2 et pour fournir les impulsions P2 correspondantes. Dans cet exemple, les impulsions P1 sont positives et ont chacune un niveau égal à A1, les impulsions P2 étant alors négatives et ayant chacune un niveau égal à - A2. A titre d'exemple, le circuit 212 comprend un ou plusieurs éléments résistifs et/ou un interrupteur commandé par le signal CMD2.

Dans l'exemple de la figure 2, le circuit INT comprend un amplificateur opérationnel 214 monté en intégrateur, le montage intégrateur de l'amplificateur opérationnel 214 n'étant pas détaillé en figure 2. L'amplificateur 214 comprend une première entrée couplée, de préférence connectée, à un noeud 216 configuré pour recevoir les impulsions P1, P2 et P3. Une sortie de l'amplificateur 214 fournit le signal RES1.

A titre d'exemple, comme cela est illustré en figure 2, le circuit C3 peut comprendre un comparateur 218, par exemple mis en œuvre à partir d'un amplificateur opérationnel. Le comparateur 218 a une entrée recevant le signal RES1, une autre entrée recevant le niveau ref auquel est comparé le signal RES1, et une sortie fournissant un signal comp1 binaire à un premier état, par exemple l'état haut, lorsque le signal RES1 est supérieur au niveau ref et à un deuxième état, par exemple l'état bas, lorsque le signal RES1 est inférieur au niveau ref. Le signal comp1 correspond à la quantification sur un bit, ou quantification binaire, du signal RES1. Le circuit C3 peut alors également comprendre, comme cela est illustré en figure 2, un élément mémorisant 220 cadencé par le signal CMD3. L'élément 220 est configuré pour fournir le bit OUT1 à partir du bit comp1, par exemple pour mettre à jour l'état du bit OUT1 à partir de l'état du bit comp1 à chaque début d'une impulsion CMD3. Dit autrement, l'élément 220 est configuré pour échantillonner le bit comp1, par exemple à chaque front montant ou descendant du signal CMD3, et mémoriser sur le bit OUT1 le niveau échantillonné du bit comp1. A titre d'exemple, l'élément 220 est une bascule de type D ("D flip-flop" en anglais) ayant une entrée de donnée D recevant le signal comp1, une entrée d'horloge C recevant le signal CMD3 et étant active sur front montant du signal CMD3, et une sortie Q fournissant le bit OUT1.

Dans l'exemple de la figure 2, le circuit C4 correspond à un circuit 222 (bloc "-A3/+A3" en figure 2). Le circuit 222 reçoit le signal OUT1 et le signal CMD3 et fournit les impulsions P3 correspondantes. A titre d'exemple, le circuit 222 comprend un ou plusieurs éléments résistifs et/ou un interrupteur commandé par le signal CMD3.

On considère à titre d'exemple le cas où une impulsion P1, P2 ou P3 positive, respectivement négative, en entrée de l'intégrateur 214 provoque une augmentation, respectivement une diminution, du signal RES1. Dans cet exemple, après chaque mise à jour du bit OUT1, le circuit 222 fournit une impulsion P3 négative d'amplitude A3 lorsque le bit OUT1 est à un état binaire indiquant que le signal RES1 est supérieur au niveau ref et une impulsion P3 positive d'amplitude A3 lorsque le bit OUT1 est à un état binaire indiquant que le signal RES1 est inférieur au niveau ref. Dit autrement, après chaque mise à jour du bit OUT1, le circuit 222 fournit une impulsion P3 de niveau égal à -A3 lorsque le bit OUT1 indique que le signal RES1 est supérieur au niveau ref, et de niveau égal à +A3 lorsque le bit OUT1 indique que le signal RES1 est inférieur au niveau ref.

La personne du métier sera en mesure de déduire de l'exemple ci-dessus, la polarité des impulsions P3 en fonction de l'état du bit OUT1 dans le cas où une impulsion P1, P2 ou P3 positive, respectivement négative, en entrée de l'intégrateur 214 provoque une diminution, respectivement une augmentation, du signal RES1.

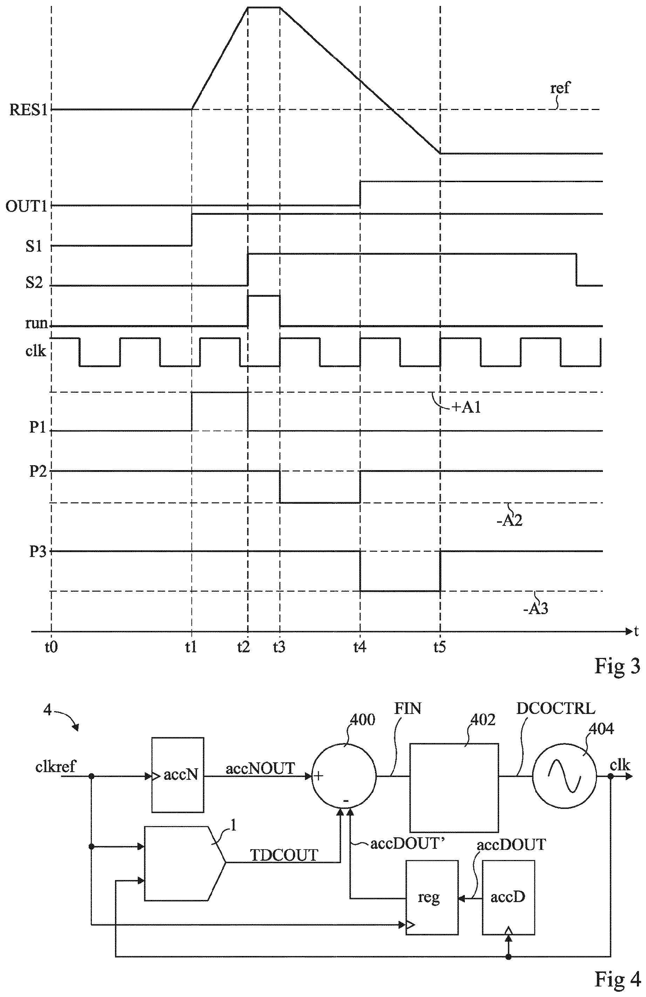

La figure 3 illustre, par des chronogrammes, un exemple de fonctionnement du convertisseur 1 de la figure 1 lorsqu'il est mis en œuvre de la manière décrite en relation avec la figure 2. Dans l'exemple de la figure 3, K2 et K3 sont égaux chacun à 1, et les amplitudes A2 et A3 sont égales à 0,5 fois l'amplitude A1, bien que la personne du métier soit en mesure d'adapter la description faite ci-dessous au cas où K2, K2, A1, A2 et A3 ont d'autres valeurs. Dans cet exemple, une impulsion P1, P2 ou P3 positive, respectivement négative, en entrée de l'intégrateur 214 provoque une augmentation, respectivement une diminution, du signal RES1, et, en outre, que le bit OUT1 est mis à jour à l'état haut, respectivement bas, lorsqu'au moment de cette mise à jour le signal RES1 est supérieur, respectivement inférieur, au niveau ref.

A titre d'exemple, à un instant t0, la sortie RES1 du circuit INT et les signaux P1, P2 et P3 sont à leur niveau zéro, les signaux S1 et S2, run et OUT étant à l'état bas.

La figure 3 illustre un seul cycle de fonctionnement du convertisseur 1, c'est-à-dire la succession d'étapes répétées après chaque front actif du signal S1.

A un instant t1 postérieur à l'instant t0, le signal S1 commute à l'état haut. Le front montant du signal S1 entraîne que le signal CMD1 (non représenté en figure 3) commute à l'état haut et que le signal P1 commute au niveau +A1. Dit autrement, le front montant du signal S1 provoque le début d'une impulsion CMD1 et d'une impulsion P1.

A partir de l'instant t1, du fait que le circuit INT reçoit l'impulsion P1 positive, le signal RES1 varie, dans cet exemple augmente, avec une pente proportionnelle au niveau de l'impulsion P1, chaque impulsion P1 ayant ici un niveau égal à +A1.

A un instant t2 postérieur à l'instant t1, le signal S2 commute à l'état haut. Le front montant du signal S2 entraîne que le signal CMD1 (non représenté en figure 3) commute à l'état bas et que le signal P1 retrouve son niveau zéro. Dit autrement, le front montant du signal S2 provoque la fin des impulsions CMD1 et P1. Il en résulte que le signal RES1 cesse de varier et mémorise sa valeur à l'instant t2.

En outre, la fin de l'impulsion CMD1 (non représentée en figure 3), c'est-à-dire le front descendant du signal CMD1 reçu par la bascule 206, provoque la commutation à l'état haut du signal run.

Un instant t3 postérieur à l'instant t2 correspond au premier front montant du signal clk suivant la fin de l'impulsion P1. Ce front montant du signal clk provoque la commutation à l'état haut du signal CMD2 (non représenté en figure 3) et au niveau -A2 du signal P2. Dit autrement, ce front du signal clk provoque le début d'une impulsion CMD2 et d'une impulsion P2. En outre, le début de l'impulsion CMD2 entraîne la commutation à l'état bas du signal run.

A partir de l'instant t3, du fait que le circuit INT reçoit l'impulsion P2 négative, le signal RES1 varie, dans cet exemple diminue, avec une pente proportionnelle au niveau de l'impulsion P2, chaque impulsion P2 ayant ici un niveau égal à -A2.

Un instant t4 postérieur à l'instant t3 correspond au front montant suivant du signal clk. Ce front montant du signal clk entraine que le signal CMD2 (non représenté en figure 3) commute à l'état bas et que le signal P2 retrouve son niveau zéro. Dit autrement, le front montant du signal clk provoque la fin des impulsions CMD2 et P2. En outre, ce front montant du signal clk provoque la commutation à l'état haut du signal CMD3 (non illustrée en figure 3), donc la mise à jour du bit OUT1 et le début d'une impulsion P3.

Dans cet exemple, lors de sa mise à jour à l'instant t4, le bit OUT1 commute à l'état haut du fait que le signal RES1 est supérieur au niveau ref à l'instant t4.

Dans cet exemple, l'état haut du bit OUT1 résulte donc en une impulsion P3 négative d'amplitude A3, c'est-à-dire une impulsion de niveau égal à -A3, et l'état bas du bit OUT1 résulte en une impulsion P3 positive d'amplitude A3, c'est-à-dire une impulsion de niveau égal à +A3. Ainsi, dans cet exemple, l'impulsion P3 débutant à l'instant t4 a un niveau égal à -A3 car le bit OUT1 est à l'état haut.

A partir de l'instant t4, du fait que le circuit INT reçoit l'impulsion P3, le signal RES1 varie avec une pente proportionnelle au niveau de l'impulsion P3. Plus particulièrement, dans cet exemple, le signal RES1 diminue avec une pente proportionnelle au niveau négatif -A3 de l'impulsion P3.

Un instant t5 postérieur à l'instant t4 correspond au front montant suivant du signal clk. Ce front montant du signal clk provoque la commutation à l'état bas du signal CMD3, donc la fin de l'impulsion P3, c'est-à-dire le retour au niveau zéro du signal P3.

En outre, à partir de l'instant t5, tant le circuit INT ne reçoit plus d'impulsion P1, P2 ou P3, le signal RES1 mémorise, ou garde, sa valeur à l'instant t5.

Après l'instant t5, chaque nouveau front montant du signal S1 provoque un nouveau cycle de fonctionnement du convertisseur 1, c'est-à-dire une nouvelle succession d'impulsions P1, P2 et P3, une modification du signal RES1 à partir de sa valeur courante, et une mise à jour du bit OUT1 sur la base du signal RES1.

La figure 4 illustre un exemple d'une boucle à verrouillage de phase en tout numérique 4, selon un mode de réalisation, où la boucle à verrouillage de phase 4 comprend le convertisseur 1.

La boucle à verrouillage de phase 4 est configurée pour recevoir un signal clkref à une première fréquence et pour fournir le signal clk à une deuxième fréquence égale à N/D fois la première fréquence, avec N et D deux valeurs positives. De préférence, D est supérieur ou égal à 1, et N est supérieur à 1 et en général à D.

La boucle à verrouillage de phase 4 comprend le convertisseur 1. Le convertisseur 1 comprend une entrée configurée pour recevoir le signal clkref, qui correspond alors au signal S1 décrit en relation avec les figures 1 et 2, et une deuxième entrée configurée pour recevoir le signal clk. Dans l'exemple de mode de réalisation illustré par la figure 4, les signaux S2 (voir figures 1 et 2) et clk du convertisseur 1 sont confondus.

Le convertisseur 1 fournit un signal de sortie TDCOUT. Lorsque le convertisseur 1 est du type décrit en relation avec la figure 1 ou la figure 2, le signal TDCOUT est par exemple égal au bit OUT.

En figure 4, la boucle à verrouillage de phase 4 comprend un circuit accN, un circuit accD, un registre reg, un circuit arithmétique numérique 400, un filtre numérique passe-bas 402 et un oscillateur à commande numérique 404.

Le circuit accN est configuré pour fournir un signal numérique accNOUT incrémenté de la valeur N à la fréquence du signal clkref. Dit autrement, à chaque front actif du signal clkref, le signal accNOUT est incrémenté de la valeur N. Dit encore autrement, le signal accNOUT représente la phase accumulée du signal clkref.

Le circuit accD est configuré pour fournir un signal numérique accDOUT incrémenté de la valeur D à la fréquence du signal clk. Dit autrement, à chaque front actif du signal clk, le signal accDOUT est incrémenté de la valeur D.

Le circuit reg est configuré pour échantillonner le signal accDOUT en synchronisme avec le signal clkref, par exemple en synchronisme avec les fronts actifs du signal clkref, et pour fournir un signal accDOUT' correspondant à la mémorisation de cet échantillonnage. Dit autrement, le circuit reg recopie le signal accDOUT sur sa sortie accDOUT' à chaque front actif du signal clkref. Dit encore autrement, le signal accDOUT' représente la phase accumulée du signal clk échantillonné par clkref.

Les circuits accD et reg forment donc un circuit configuré pour fournir le signal accDOUT incrémenté de la valeur D à la fréquence du signal clk et le signal accDOUT' correspondant à l'échantillonnage par le signal clkref du signal accDOUT. Dit autrement, les circuits accD et reg forment un circuit configuré pour fournir le signal accDOUT' correspondant à l'échantillonnage, par le signal clkref, du signal accDOUT incrémenté de la valeur D à la fréquence du signal clk.

Le filtre numérique 402, en pratique un filtre passe-bas, est configuré pour recevoir et filtrer un résultat FIN d'une soustraction du signal TDCOUT de sortie du convertisseur 1 et du signal accDOUT' au signal accNOUT, et pour commander l'oscillateur 404. Ainsi, le circuit 400 est configuré pour recevoir les signaux TDCOUT, accNOUT et accDOUT' et pour fournir, en entrée du filtre 402, le signal numérique FIN correspondant au signal numérique accNOUT auquel ont été soustraits les signaux numériques TDCOUT et accDOUT'.

Le filtre 402 fournit un signal numérique DCOCTRL de commande à l'oscillateur 404. Le signal DCOCTRL correspond au résultat du filtrage passe-bas du signal FIN par le filtre 402. A titre d'exemple, la fonction de transfert en z du filtre 402 peut être du type a+ (b/(1-z⁻¹)).

L'oscillateur 404 est configuré pour fournir le signal clk à une fréquence déterminée par la valeur de sortie du filtre 402, c'est-à-dire par la valeur du signal DCOCTRL.

Dans la boucle à verrouillage de phase 4, la soustraction du signal accDOUT' au signal accNOUT représente l'erreur de phase de la boucle, entachée d'une erreur de phase résiduelle PhiError entre la fréquence du signal clkref et celle du signal clk. Cette erreur PhiError est en pratique égale au rapport d'une valeur DeltaT sur une période Tclk du signal clk, avec DeltaT la durée séparant chaque front du signal clkref du front suivant du signal clk. La prévision du convertisseur 1 et la soustraction du signal TDCOUT au résultat de la soustraction du signal accDOUT' au signal accNOUT permet de supprimer l'erreur de phase résiduelle PhiError dans le signal FIN représentatif de l'erreur de phase de la boucle 4.

Bien que cela ne soit pas illustré ici, le convertisseur 1 peut être mis en œuvre dans des boucles à verrouillage de phase en tout numérique différentes de celle de la figure 4. Par exemple, le convertisseur 1 peut être mis en œuvre dans une boucle à verrouillage de phase en tout numérique ne comprenant pas les circuits accN, accD, reg et 400, dans laquelle la sortie TDCOUT du convertisseur 1 est directement fournie au filtre 402, le convertisseur 1 reçoit le signal clkref ou un signal obtenu par une division par D de la fréquence du signal clk et le signal clk ou un signal obtenu par une division par N de la fréquence du signal clk.

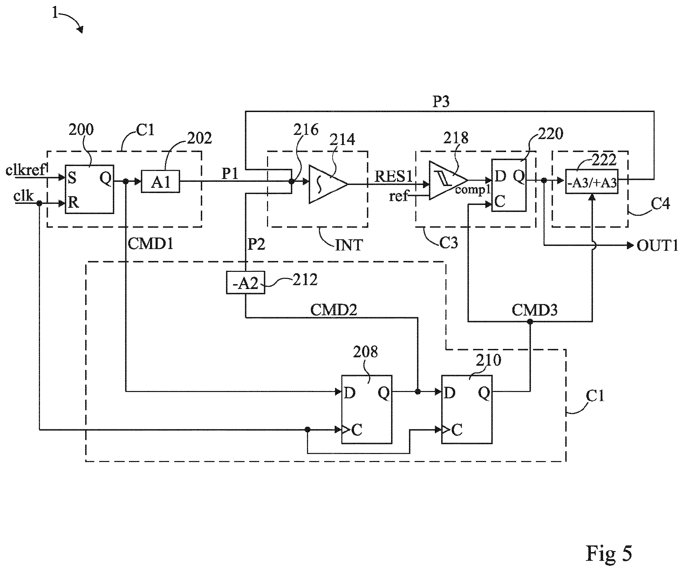

La figure 5 représente, de manière schématique, des détails d'un exemple de mode de réalisation du convertisseur 1 de la figure 1, dans un cas où le convertisseur est mis en œuvre dans une boucle à verrouillage de phase du type de celle de la figure 4.

Dans cet exemple de mode de réalisation, les signaux S2 (figures 1 et 2) et clk sont confondus, et les signaux S1 (figures 1 et 2) et clkref sont confondus. En outre, dans cet exemple, la durée des impulsions P2 et P3 est égale à une période Tclk du signal clk (K2=K3=1), et les amplitudes A2 et A3 sont égales à 0,5 fois l'amplitude A1. Ainsi, la durée maximale Dmax des impulsions P1 est égale à Tclk, et, dans cet exemple où les impulsions P1 débutent avec les fronts montants du signal S1 et se terminent avec les fronts montants du signal S2, la dynamique du convertisseur 1 est également égale à Dmax=Tclk.

Le convertisseur 1 de la figure 5 est similaire au convertisseur 1 de la figure 3, et seules les différences entre ces convertisseurs sont ici mises en exergue.

En particulier, du fait que les signaux S2 et clk sont confondus, la bascule 206 (figure 2) du circuit C1 est omise, et l'entrée de donnée D de la bascule 208 du circuit C1 reçoit directement le signal CMD1.

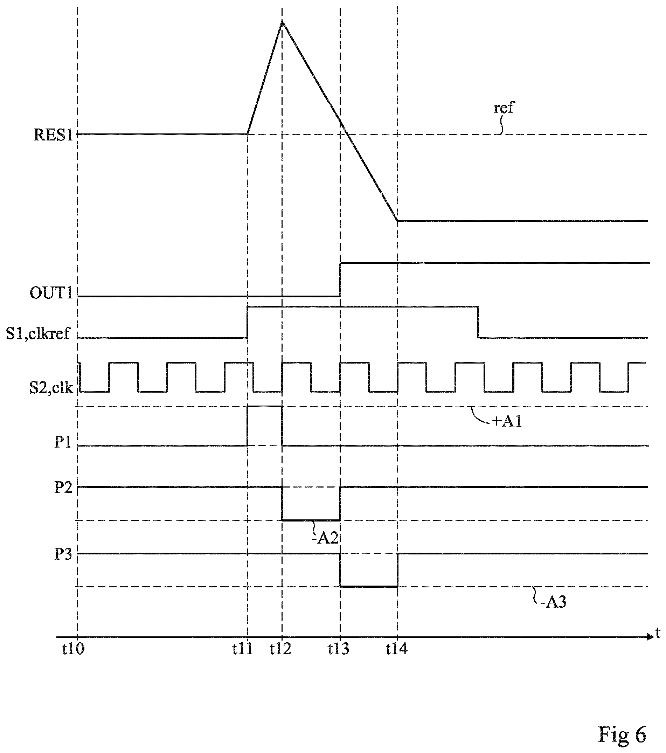

La figure 6 illustre, par des chronogrammes, le fonctionnement du convertisseur 1 de la figure 5.

Les chronogrammes de la figure 6 sont similaires à ceux de la figure 3, et seules les différences entre ces derniers seront ici mises en exergue. En particulier, la figure 6 ne comprend pas le signal run du fait que le convertisseur 1 de la figure 5 ne comprend pas ce signal. Dans l'exemple de la figure 6, comme dans l'exemple de la figure 3, une impulsion P1, P2 ou P3 positive, respectivement négative, en entrée de l'intégrateur 214 provoque une augmentation, respectivement une diminution, du signal RES1, et le bit OUT1 est mis à jour à l'état haut, respectivement bas, lorsqu'au moment de cette mise à jour le signal RES1 est supérieur, respectivement inférieur, au niveau ref.

En figure 6, un instant t10 correspond à l'instant t0 décrit en relation avec la figure 3.

En figure 6, un instant t11 postérieur à l'instant t10 correspond à l'instant t1 décrit en relation avec la figure 3, c'est-à-dire à un front actif (dans cet exemple un front montant) du signal clkref.

En figure 6, un instant t12 postérieur à l'instant t11 correspond au premier front actif (dans cet exemple un front montant) du signal clk suivant le front montant du signal clkref à l'instant t11. Ce front montant du signal clk entraine la fin des impulsions P1 et CMD1, le signal CMD1 n'étant pas représenté en figure 6. En outre, ce front montant du signal clk entraîne le début des impulsions CMD2 et P2, le signal CMD2 n'étant pas représentée en figure 6.

Dit autrement, en figure 6, les instants t2 (fin de l'impulsion P1) et t3 (début de l'impulsion P2) décrits en relation avec la figure 3 sont confondus et correspondent à l'instant t12.

En figure 6, un instant t13 postérieur à l'instant t12 correspond à l'instant t4 décrit en relation avec la figure 3 (front montant du signal clk, fin de l'impulsion P2 et début de l'impulsion P3), et un instant t14 postérieur à l'instant t13 correspond à l'instant t5 décrit en relation avec la figure 3 (front montant du signal clk et fin de l'impulsion P3).

Après l'instant t14, chaque nouveau front montant du signal clkref provoque un nouveau cycle de fonctionnement du convertisseur 1, c'est-à-dire une nouvelle succession d'impulsions P1, P2 et P3, une modification du signal RES1 à partir de sa valeur courante, et une mise à jour du bit OUT1 sur la base du signal RES1.

La personne du métier est en mesure de comprendre que, dans l'exemple illustré par la figure 6, la fréquence du signal clk est au moins trois fois plus grande que celle du signal clkref pour que le convertisseur 1 ait le temps de générer et intégrer trois impulsions P1, P2 et P3 successives après chaque front actif du signal clkref et avant le front actif suivant du signal clkref.

Dans le convertisseur 1 de la figure 5, du fait que l'amplitude crête-à-crête du signal P3 est égale à 2*A3 et est égal à celle du signal P1, à savoir A1, le convertisseur normalise de fait la valeur du bit OUT1 sur une période du signal clk. Dit autrement, le bit OUT1 représente la valeur de l'erreur de phase résiduelle PhiError et peut être fourni tel quel en entrée du circuit 400 de la boucle à verrouillage de phase 4 décrite en relation avec la figure 4.

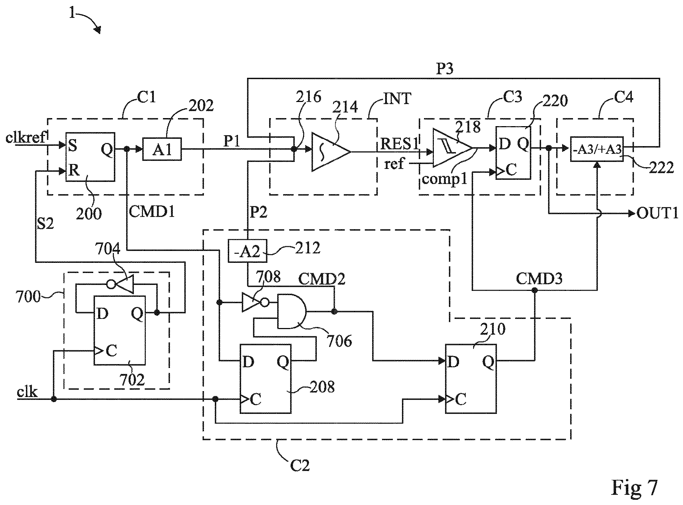

La figure 7 représente, de manière schématique, des détails d'un autre exemple de mode de réalisation du convertisseur temps numérique de la figure 1, dans un cas où le convertisseur est mis en œuvre dans une boucle à verrouillage de phase du type de celle de la figure 4.

En particulier, le mode de réalisation de la figure 7 diffère de celui de la figure 5 en ce que le signal S2 (figures 1 et 2) est obtenu en divisant par deux la fréquence du signal clk.

En outre, dans cet exemple, la durée des impulsions P2 et P3 est égale à une période Tclk du signal clk (K2=K3=1) et les amplitudes A2 et A3 sont égales. Dans cet exemple où les impulsions P1 débutent avec les fronts montants du signal S1 et se terminent avec les fronts montants du signal S2, la durée maximale Dmax des impulsions P1 est alors égale 2*Tclk, d'où il résulte que l'amplitude A1 est égale à l'amplitude A2 et à l'amplitude A3, la dynamique du convertisseur 1 étant également égale à Dmax=2*Tclk.

Plus particulièrement, le convertisseur 1 de la figure 7 diffère de celui de la figure 5 par la mise en œuvre de son circuit C2 et de son circuit C1, et par le fait qu'il comprend en outre un circuit 700. Le circuit 700 est un diviseur de fréquence. Dit autrement, le circuit 700 est configuré pour fournir un signal à une fréquence divisée par rapport à la fréquence d'un signal d'entrée du circuit 700.

Le circuit 700 est configuré pour recevoir le signal clk, et pour fournir le signal S2, ce dernier ayant, dans cet exemple, une fréquence deux fois plus faible que celle du signal clk. Dans d'autres variantes de réalisation non illustrées, la personne du métier pourra prévoir un ratio différent de deux entre la fréquence du signal clk et celle du signal S2, en adaptant alors les amplitudes des impulsions P1, P2 et/ou P3 et/ou les durées des impulsions P2 et P3 pour que toute la dynamique des impulsions P1 puisse être convertie par le convertisseur 1.

A titre d'exemple, comme cela est illustrée en figure 7, le circuit 700 comprend une bascule 702 de type D. La bascule 702 comprend une entrée d'horloge C configurée pour recevoir le signal clk, l'entrée C étant sensible aux fronts actifs du signal clk, à savoir les fronts montants dans cet exemple, une sortie Q configurée pour fournir le signal S2, et une entrée de donnée D configurée pour recevoir l'inverse de la sortie Q. A titre d'exemple, l'inverse de la sortie Q est fourni à l'entrée D de la bascule 702 par un inverseur 704. L'inverseur 704 a par exemple une entrée connectée à la sortie Q de la bascule 702 et une sortie connectée à l'entrée D de la bascule.

Dans cet exemple, le circuit C1 de la figure 7, et plus particulièrement son circuit 202, diffèrent de ceux de la figure 5 en ce que les impulsions P1 qu'ils fournissent ont chacune une amplitude A1 égale aux amplitudes A2 et A3, et non pas à deux fois les amplitudes A2 et A3 comme c'était le cas dans l'exemple de la figure 5. A titre d'exemple, le circuit 202 comprend un ou plusieurs éléments résistifs et/ou un interrupteur commandé par le signal CMD1.

Par rapport au convertisseur 1 décrit en relation avec les figures 2 et 5, dans le convertisseur 1 de la figure 7, les impulsions P1, qui débutent chacune lors d'un front actif du signal S1 et se terminent chacune lors du front actif suivant du signal S2, ont une durée maximale Dmax égale à deux périodes Tclk du signal clk. Ainsi, le circuit C2 est modifié pour qu'à chaque impulsion P1, l'impulsion P2 correspondante ne débute qu'une fois l'impulsion P1 terminée.

Dans l'exemple de la figure 7, par rapport à ce qui a été décrit en relation avec la figure 5, le signal CMD2 n'est pas directement disponible en sortie de la bascule 208 du circuit C2. Plus particulièrement, en figure 7, la bascule 208 a toujours une entrée D configurée pour recevoir le signal CMD1 et une entrée C configurée pour recevoir le signal clk et pour être sensible aux fronts actifs du signal clk. Toutefois, le circuit C2 comprend un circuit logique configuré pour fournir une impulsion CMD2 uniquement lorsque la sortie Q de la bascule 208 a commuté suite à une impulsion P1 et que cette impulsion P1 est terminée. Par exemple, ce circuit logique est configuré pour mettre en œuvre le ET logique entre l'inverse du signal CMD1 et la sortie Q de la bascule 208, le résultat de cette opération logique étant le signal CMD2. A titre d'exemple illustré par la figure 7, ce circuit logique comprend une porte ET 706 ayant une entrée connectée à la sortie Q de la bascule 208 et une autre entrée connectée à la sortie d'un inverseur 708 dont l'entrée reçoit le signal CMD1, la porte 706 ayant une sortie fournissant le signal CMD2. Bien entendu, la personne du métier est en mesure de prévoir d'autres exemples de mise en œuvre de ce circuit logique.

Comme en figures 2 et 5, le signal CMD2 est fourni à l'entrée D de la bascule 210 du circuit C1.

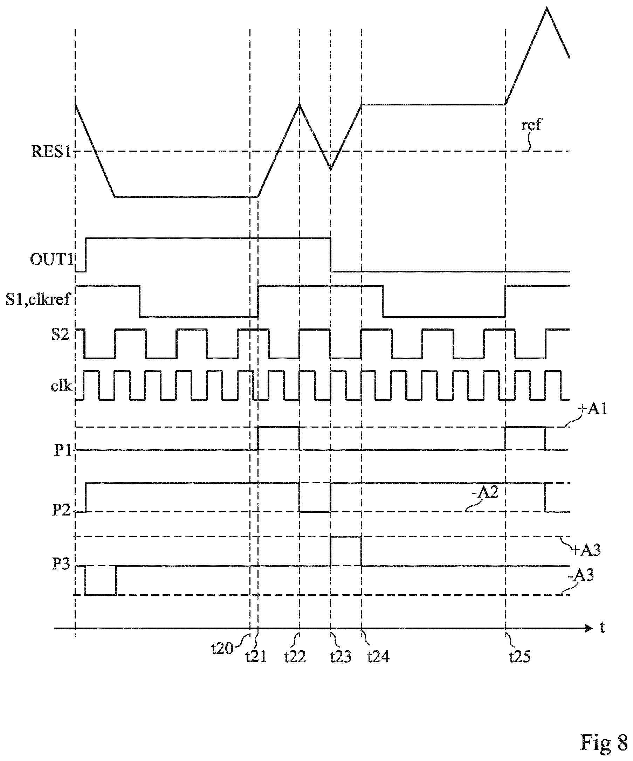

La figure 8 illustre, par des chronogrammes, un exemple de fonctionnement du convertisseur 1 de la figure 7. En figure 8, le signal S2 est obtenu en divisant par deux la fréquence du signal clk, et les signaux S1 et clkref sont confondus.

Dans l'exemple de la figure 8, comme dans les exemples des figures 3 et 6, une impulsion P1, P2 ou P3 positive, respectivement négative, en entrée de l'intégrateur 214 provoque une augmentation, respectivement une diminution, du signal RES1, et le bit OUT1 est mis à jour à l'état haut, respectivement bas, lorsqu'au moment de cette mise à jour le signal RES1 est supérieur, respectivement inférieur, au niveau ref.

A titre d'exemple, à un instant t20, la sortie RES1 du circuit INT est à une valeur constante ou mémorisée, dans cet exemple négative par rapport au niveau ref. En outre, les signaux P1, P2 et P3 sont à leurs niveaux zéro, le signal clkref est à l'état bas, et le bit OUT1 est à l'état haut.

A un instant t21 postérieur à l'instant t20, le signal clkref commute à l'état haut, ce qui provoque un front montant du signal CMD1 (non représenté en figure 8) et le passage du signal P1 au niveau +A1. Dit autrement, le front montant du signal clkref provoque le début d'une impulsion CMD1 et d'une impulsion P1.

A partir de l'instant t21, du fait que le circuit INT (figure 7) reçoit l'impulsion P1 positive, le signal RES1 varie, dans cet exemple augmente, avec une pente proportionnelle au niveau +A1 de l'impulsion P1. Chaque impulsion P1 a ici une amplitude égale à A1.

A un instant t22 postérieur à l'instant t21, le signal S2 commute à l'état haut. Le front montant du signal S2 entraîne que le signal CMD1 (non représenté en figure 8) commute à l'état bas et que le signal P1 commute à son niveau zéro. Dit autrement, le front montant du signal S2 provoque la fin de l'impulsion CM1 et de l'impulsion P1.

En outre, la fin de l'impulsion CMD1 (non représentée en figure 8), provoque le début d'une impulsion CMD2 (non représentée en figure 8), donc le début d'une impulsion P2.

A partir de l'instant t22, du fait que le circuit INT (figure 7) reçoit l'impulsion P2 négative, le signal RES1 varie, dans cet exemple diminue, avec une pente proportionnelle au niveau -A2 de l'impulsion P2. Chaque impulsion P2 a ici une amplitude égale à A2.

Un instant t23 postérieur à l'instant t22 correspond au front montant suivant du signal clk. Ce front montant du signal clk entraîne que le signal CMD2 (non représenté en figure 8) commute à l'état bas et que du signal P2 commute à son niveau zéro. Dit autrement, ce front du signal clk provoque la fin des impulsions CMD2 et P2.

En outre, le front montant du signal clk à l'instant t23 provoque la commutation à l'état haut du signal CMD3 (non représenté en figure 8), donc la mise à jour du bit OUT1 et le début d'une impulsion P3.

Dans cet exemple, à l'instant t23, le bit OUT1 commute à l'état bas du fait que, à cet instant t23, le signal RES1 est inférieur au niveau ref. En outre, dans cet exemple, l'état bas du bit OUT1 résulte en une impulsion P3 positive de niveau +A3, et l'état haut du bit OUT1 résulte en une impulsion P3 négative de niveau -A3. Ainsi, dans cet exemple, l'impulsion P3 débutant l'instant t23 a un niveau égal à +A3 car le bit OUT1 est à l'état bas à partir de l'instant t23.

A partir de l'instant t23, du fait que le circuit INT reçoit l'impulsion positive P3, le signal RES1 varie avec une pente proportionnelle au niveau +A3 de l'impulsion P3. Plus particulièrement, dans cet exemple, le signal RES1 augmente avec une pente proportionnelle au niveau +A3 de l'impulsion P3.

Un instant t24 postérieur à l'instant t23 correspond au front montant suivant du signal clk. Ce front montant du signal clk provoque la commutation à l'état bas du signal CMD3, donc la fin de l'impulsion P3.

En outre, à partir de l'instant t24, tant que le circuit INT ne reçoit plus d'impulsion P1, P2 ou P3, le signal RES1 mémorise sa valeur à l'instant t24.

Après l'instant t24, chaque nouveau front montant du signal S1 (par exemple à l'instant t25 postérieur à l'instant t24) provoque un nouveau cycle de fonctionnement du convertisseur 1, c'est-à-dire une nouvelle succession d'impulsions P1, P2 et P3, une modification du signal RES1 à partir de sa valeur courante, et une mise à jour du bit OUT1 sur la base du signal RES1.

La personne du métier est en mesure de comprendre que, dans l'exemple illustré par la figure 8, la fréquence du signal clk est au moins quatre fois plus grande que celle du signal clkref pour que le convertisseur 1 ait le temps de générer et intégrer trois impulsions P1, P2 et P3 successives après chaque front actif du signal clkref et avant le front actif suivant du signal clkref.

Lorsque le convertisseur 1 de la figure 7 est mis en œuvre dans une boucle à verrouillage de phase du type de celle de la figure 4, du fait que la durée maximale Dmax que peuvent prendre les impulsions P1 est égale à deux périodes Tclk du signal clk, le bit OUT1 du convertisseur 1 est alors représentatif d'une erreur de phase résiduelle proportionnelle à deux fois l'erreur de phase résiduelle PhiError entre les signaux clk et clkref. La boucle à verrouillage de phase 4 décrite en relation avec la figure 4 est alors modifiée en conséquence.

Par exemple, le circuit accD est modifié pour être cadencé par le signal S2 plutôt que par le signal clk, c'est à dire que le signal accDOUT est alors incrémenté à la fréquence du signal S2.

En outre, lorsque le circuit accD est modifié de cette façon, pour que la boucle 4 garde la même fonction de transfert en fréquence qu'avec le convertisseur 1 de la figure 5, le circuit accD peut alors être configuré pour incrémenter le signal accDOUT de la valeur D/2 à chaque front actif du signal S2, si la valeur de D est paire. En variante, pour que la boucle 4 garde la même fonction de transfert en fréquence, par exemple quand la valeur de D est impaire, le circuit accN peut alors être configuré pour incrémenter le signal accNOUT de deux fois la valeur N à chaque front montant du signal clkref.

Bien que l'on ait décrit en relation avec les figures 7 et 8 le cas où le signal S2 est obtenu en divisant par deux la fréquence du signal clk, la personne du métier est mesure d'adapter cette description au cas où le signal S2 est obtenu par division entière différente de deux du signal clk, par exemple en modifiant en conséquence les durées et/ou les amplitudes des impulsions P1, P2 et P3 de manière que toute la dynamique des impulsions P1 puisse être convertie par le convertisseur 1.

En outre, on a décrit en relation avec les figures 7 et 8, un exemple d'un mode de réalisation du convertisseur 1 dans le cas où celui-ci est mis en œuvre dans une boucle à verrouillage de phase du type de celle de la figure 4. La personne du métier est en mesure d'adapter le convertisseur 1 de la figure 7 à une mise en œuvre dans un circuit autre qu'une boucle à verrouillage de phase. Par exemple, pour cela, le circuit C2 du convertisseur 1 de la figure 7 est modifié pour comprendre la bascule 206 de manière à générer le signal run, ce signal run étant fourni en entrée de la bascule 208 et du circuit logique 708, 706 en lieu et place du signal CMD1.

Le convertisseur 1 de type sigma-delta décrit en relation avec les figures 1 à 8 est d'ordre 1, c'est-à-dire que l'erreur de quantification n'est intégrée qu'une seule fois à chaque cycle de fonctionnement. Dans ce cas, la pente de mise en forme du bruit est, par exemple, de 20dB par décade.

Le convertisseur 1 peut être modifié selon une architecture à mise en forme de bruit à étage multiple (MASH de l'anglais "Multi-Stage Noise Shaping"), de sorte que le convertisseur 1 est alors d'ordre supérieur à 1, l'ordre du convertisseur 1 correspondant alors au nombre d'intégrations de l'erreur de quantification par cycle de fonctionnement du convertisseur 1. Dans ce cas, le convertisseur 1 comprend un premier étage comprenant les circuits INT, C1, C2, C3 et C4 décrits précédemment, et un deuxième étage configuré pour recevoir le signal de sortie RES1 du circuit INT du premier étage, et pour générer, en sortie du deuxième étage, un signal numérique à partir du signal RES1, de préférence en mettant en œuvre une intégration d'un signal déterminé par le signal RES1. Le signal numérique de sortie TDCOUT du convertisseur 1 est alors déterminé au moins en partie par le bit OUT1 et le signal numérique de sortie du deuxième étage.

Selon un mode de réalisation, le deuxième étage est configuré pour :
générer, après chaque impulsion P3, une impulsion CMD4 débutant en synchronisme avec le signal clk ;
intégrer, pendant chaque impulsion P4, une somme du signal RES1 de sortie du circuit INT et d'un signal CR de contre réaction, quantifier sur un bit un résultat RES2 de ladite intégration et mémoriser sur un bit OUT2 ladite quantification binaire à la fin de l'impulsion CMD4 ;
générer, pendant chaque impulsion P3, une impulsion P4 à partir du bit OUT2, et le signal CR en intégrant l'impulsion P4 ; et
mémoriser le bit OUT2 sur un bit OUT2-1 à chaque front actif du signal S2, le signal numérique de sortie du deuxième étage étant généré à partir des bits OUT2 et OUT2-1 ou correspondant aux bits OUT2 et OUT2-1.

Dit autrement, le deuxième étage est configuré pour recevoir en entrée l'erreur de quantification résiduelle disponible en sortie du circuit INT après chaque impulsion P3, et pour l'intégrer une nouvelle fois. En outre, le deuxième étage met en œuvre une contre réaction négative sigma-delta grâce au signal CR déterminé à partir du bit OUT2. La détermination du signal CR est mise en œuvre, après chaque cycle de fonctionnement du convertisseur et avant le début de l'impulsion CMD4 correspondante. Pendant chaque impulsion CMD4, le signal CR est sommé au signal RES1 et le deuxième étage intègre la somme S des signaux RES1 et CR. Le résultat RES2 de cette intégration est quantifié et mémorisé sur le bit OUT2.

A titre d'exemple, la sortie TDCOUT du convertisseur 1 d'ordre 2 est obtenu en sommant la sortie OUT1 du premier étage avec la dérivée mathématique du signal OUT2 du deuxième étage.

A titre d'exemple, la contre réaction négative, c'est-à-dire la détermination du signal CR, comprend l'intégration de l'impulsion P4 dont le signe est déterminé par l'état du bit OUT2. Le résultat de cette intégration correspond alors au signal CR et est réinitialisé avant chaque nouvelle intégration d'une impulsion P4, donc à chaque cycle de fonctionnement du convertisseur 1. A titre d'exemple, du fait que chaque impulsion P4 est générée pendant une impulsion CMD3, la durée de chaque impulsion P4 est égale à K4*Tclk, avec K4 un nombre entier strictement positif égal à K3.

Du fait que le deuxième étage met en œuvre une deuxième intégration de l'erreur de quantification, la pente de mise en forme du bruit est, par exemple, au moins de 40dB par décade et dépend du nombre d'étages cascadés dans le convertisseur 1, la pente étant, par exemple, égale à 40 dB par décade lorsque le convertisseur 1 sigma-delta de type MASH comprend exactement deux étages.

La mise en forme plus importante du bruit résultant de l'augmentation de l'ordre du convertisseur 1 permet de réduire encore plus le bruit basse fréquence. En outre, l'augmentation de l'ordre du convertisseur 1 permet d'obtenir un spectre en fréquence plus pur en ce qui concerne le signal clk.

Des convertisseurs 1 de type MASH d'ordre supérieur à deux sont construits en cascadant les étages de la même façon que ce qui a été présenté pour le premier étage et le deuxième étage du convertisseur 1 d'ordre 2. Par exemple, la sortie de l'intégrateur du Nième étage N est fourni en entrée du N+1ième étage, et la sortie quantifiée et dérivée de l'étage N+1 est sommée à la sortie quantifiée de l'étage N. Pour chaque étage supplémentaire, une impulsion supplémentaire est ajoutée au cycle de fonctionnement du convertisseur 1, pour synchroniser le fonctionnement de cet étage avec les autres étages du convertisseur 1.

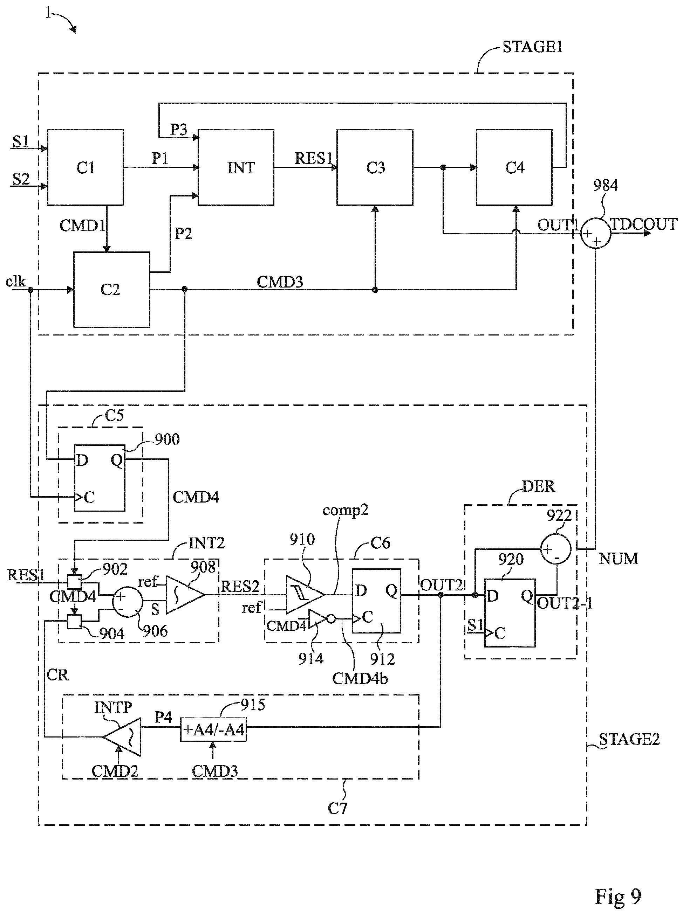

La figure 9 illustre une variante de réalisation du convertisseur 1 de la figure 1. Plus particulièrement, la figure 9 illustre un exemple de mise œuvre du convertisseur 1 lorsque celui-ci est de type MASH d'ordre 2. Dans cette figure 9, le premier étage du convertisseur 1 est référencé STAGE1 et délimité par des pointillés, le deuxième étage du convertisseur 1 étant référencé STAGE2 et délimité par des pointillés.

L'étage STAGE1 comprend les circuits C1, C2, C3, C4 et INT, représentés et connectés en figure 9 de la même façon qu'en figure 1. Le signal de sortie de l'étage STAGE1 est le bit OUT1. A titre d'exemple, les circuits C1, C2, INT, C3 et C4 sont mis en œuvre de la façon décrite en relation avec la figure 2.

L'étage STAGE2 comprend, dans cet exemple, des circuits C5, INT2, C6, C7 et DER, dont des exemples de mise en œuvre sont décrits plus en détails ci-après. La personne du métier est toutefois en mesure de prévoir d'autres exemples de mises en œuvre d'au moins l'un de ces circuits C5, INT2, C6, C7 et DER, à partir de la description fonctionnelle qui va en être faite.

Le circuit C5 est configuré pour générer, après chaque impulsion P3, une impulsion CMD4 correspondante. Chaque impulsion CMD4 a une durée égale à K4*Tclk, avec K4 un nombre entier strictement positif et égal à K3. A titre d'exemple, le circuit C5 reçoit le signal CMD3 indiquant le début et la fin de chaque impulsion P3, ce qui permet que les impulsions reçues par le circuit C5 aient toutes le même signe. Dans l'exemple illustré par la figure 9, le circuit C5 comprend une bascule 900, par exemple de type D. A titre d'exemple, la bascule 900 comprend une entrée D recevant le signal CMD3, une entrée d'horloge C recevant le signal clk, et une sortie Q fournissant les impulsions CMD4 dans cet exemple où K4=K3=1.

Le circuit INT2 est un circuit intégrateur configuré pour intégrer, pendant chaque impulsion CMD4, la somme S du signal RES1 et du signal CR. Le circuit INT2 fournit un signal RES2 correspondant au résultat de cette intégration.

A titre d'exemple, le circuit INT2 reçoit les signaux RES1, CR et CMD4. A chaque impulsion CMD4, pendant toute la durée de l'impulsion P4, le circuit INT2 est par exemple configuré pour sommer les signaux RES1 et CR et pour intégrer cette somme S.

A titre d'exemple de mise en œuvre illustré par la figure 9, le circuit INT2 comprend deux interrupteurs 902 et 904 commandés par le signal CMD4, par exemple configurés pour être passants pendant chaque impulsion CMD4, un circuit 906 et un circuit 908 intégrateur, par exemple mis en œuvre à partir d'un amplificateur opérationnel. Plus particulièrement, l'interrupteur 902 est configuré pour recevoir le signal RES1 et pour transmettre ce signal au circuit 906 uniquement pendant chaque impulsion CMD4, l'interrupteur 904 est configuré pour recevoir le signal RES1 et pour fournir ce signal au circuit 906 uniquement pendant chaque impulsion CMD4, le circuit 906 est configuré pour fournir le signal S égal à la somme des signaux qu'il reçoit des interrupteurs 902 et 904 et le circuit 908 est configuré pour intégrer le signal S. Le circuit 908 fournit le signal RES2.

Selon un autre exemple non illustré, dans le circuit INT2, les signaux RES1 et CR sont d'abord sommés, et le signal correspondant à cette somme est fourni au circuit intégrateur 908 pendant chaque impulsion CMD4, par exemple au moyen d'un interrupteur commandé par les impulsions CMD4.

Le circuit C6 est configuré pour quantifier le signal RES2 sur un bit et pour mémoriser le résultat de cette quantification binaire sur le bit OUT2 à la fin de chaque impulsion P4. La quantification du signal RES2 s'effectue en comparant le signal RES1 au niveau ref. A titre d'exemple, le circuit C6 génère un bit comp2 correspondant au résultat de la quantification binaire du signal RES2, et met à jour le bit OUT2 à partir du bit comp2.

A titre d'exemple de mise en œuvre illustré par la figure 9, le circuit C6 comprend un comparateur 910 configuré pour recevoir le signal RES2 et le niveau, ou potentiel, ref, et pour fournir le bit comp2. A titre d'exemple, le bit comp2 est à un premier état binaire lorsque le signal RES2 est supérieur au niveau ref, et à un deuxième état binaire lorsque le signal RES2 est inférieur au niveau ref. Le circuit C6 comprend également un élément mémorisant 912, par exemple une bascule, par exemple de type D, configuré pour fournir le bit OUT2 à partir du signal comp2, et mettre à jour l'état du bit OUT2 à la fin de chaque impulsion P4. Dit autrement, l'élément 912 est configuré pour échantillonner le bit comp2, par exemple à chaque front descendant du signal CMD4, et mémoriser sur le bit OUT2 le niveau échantillonné du bit comp2. Par exemple, la bascule de type D 912 comprend une entrée D configurée pour recevoir le signal comp2, une entrée d'horloge C sensible aux fronts montants et configurée pour recevoir un signal CMD4b complémentaire du signal CMD4, et une sortie Q configurée pour fournir le signal OUT2, le signal CMD4b étant par exemple disponible en sortie d'un inverseur 914 recevant le signal CMD4 comme signal d'entrée.

Le circuit C7 est configuré pour fournir le signal CR à partir du bit OUT2. Plus particulièrement, le circuit C7 est configuré, à chaque cycle de fonctionnement du convertisseur 1 et avant le début de l'impulsion CMD4 de ce cycle de fonctionnement, par exemple pendant l'impulsion CMD3 de ce cycle de fonctionnement, pour générer une impulsion P4 de même durée que les impulsions P3 et pour intégrer cette impulsion P4. En outre, chaque impulsion P4 est signée et a son signe déterminé par l'état binaire du signal OUT2. Dit autrement, le circuit C7 est configuré, à chaque impulsion CMD3, pour fournir le signal CR en intégrant, pendant cette impulsion CMD3, l'impulsion P4 déterminée à partir du bit OUT2. Les impulsions P4 ont toutes une amplitude A4, par exemple égale à l'amplitude A3 des impulsions P3.

A titre d'exemple de mise en œuvre illustré par la figure 9, le circuit C7 comprend un circuit INTP configuré pour intégrer les impulsions P4, et un circuit 915 (bloc +A4/- A4 en figure 9) configuré pour fournir les impulsions P4 à partir du bit OUT2 et du signal CMD3. Le circuit 915 fournit les impulsions P4 au circuit INTP. A la différence des circuits intégrateurs INT (non représenté en figure 9) et INT2, la sortie du circuit intégrateur INTP est réinitialisée après chaque impulsion CMD4, par exemple pendant l'impulsion P2 suivante. Par exemple, le circuit INTP reçoit le signal CMD2 et sa sortie est réinitialisée à chaque impulsion CMD2.

On considère à titre d'exemple le cas où une impulsion S positive, respectivement négative, en entrée de l'intégrateur 908 provoque une diminution, respectivement une augmentation, du signal RES2, et où une impulsion P4 positive, respectivement négative, en entrée de l'intégrateur INTP provoque une diminution, respectivement une augmentation, du signal CR. Dans cet exemple, les impulsions P4 sont négatives et ont un niveau égal à -A4 lorsque le bit OUT2 est à un état binaire indiquant que le signal RES2 est supérieur au niveau ref, et sont positives et ont un niveau égal à +A4 lorsque le bit OUT2 est à un état binaire indiquant que le signal RES2 est inférieur au niveau ref. L'amplitude A4 des impulsions P4 est, de préférence, déterminée pour que K3*A2=K4*A4, et est donc égale à l'amplitude A3 des impulsions P3 dans cet exemple où K3=K4.

La personne du métier sera en mesure de déduire de l'exemple ci-dessus, la polarité des impulsions P4 en fonction de l'état du bit OUT2 dans les cas où une impulsion S positive, respectivement négative, en entrée de l'intégrateur 918 provoque une augmentation, respectivement une diminution, du signal RES2 et/ou une impulsion P4 positive, respectivement négative, en entrée de l'intégrateur INTP provoque une augmentation, respectivement une diminution, du signal CR.

Dans cet exemple, le deuxième étage STAGE2 fournit un signal numérique de sortie NUM à partir des bits OUT2 et OUT2-1. Dans cet exemple, le circuit DER est configuré pour fournir le signal NUM à partir du bit OUT2. Plus particulièrement, le circuit DER est configuré pour générer le bit OUT2-1 à partir du bit OUT2, et pour fournir le signal NUM à partir des bits OUT2 et OUT2-1. Le circuit DER met en œuvre une fonction dérivée sur le signal OUT2, dont le résultat est le signal numérique NUM. Le circuit DER est un circuit numérique cadencé par le signal S1. Dit autrement, le circuit DER est un circuit dérivateur cadencé par le signal S1 et configuré pour fournir le signal NUM à partir du signal OUT2.

Comme le bit OUT2 représente le résultat d'une double intégration alors que le bit OUT1 représente le résultat d'une seule intégration, la mise en œuvre d'une fonction dérivée sur le signal OUT2 pour obtenir le signal NUM permet que le signal NUM soit cohérent avec le signal OUT1.

A titre d'exemple de mise en œuvre, le circuit DER comprend une bascule de type D 920 comprenant une entrée D configurée pour recevoir le signal OUT2, une entrée d'horloge C configurée pour recevoir le signal S1 et une sortie Q configurée pour fournir le signal OUT2-1. Le circuit DER comprend en outre un circuit 922 configuré pour soustraire le signal OUT2-1 au signal OUT2, le résultat de cette soustraction correspondant aux bits de sortie NUM de l'étage STAGE2. A titre d'exemple, le signal NUM correspond à deux bits et est codé en complément à 2.

Dans cet exemple où le deuxième étage fournit le signal NUM qui correspond au résultat de la dérivée du bit OUT2, le convertisseur 1 comprend en outre un circuit 984 configuré pour fournir le signal TDCOUT de sortie du convertisseur 1 à partir des signaux, ou bits, OUT1 et NUM. A titre d'exemple, le circuit 984 est configuré pour sommer les signaux NUM et OUT1 et pour fournir le signal TDCOUT qui correspond alors au résultat de cette somme. A titre d'exemple, le signal TDCOUT est un mot binaire sur trois bits, codé en complément à 2.

Dans un autre exemple, non illustré en figure 9, le deuxième étage STAGE2 ne comprend pas le circuit 922, et fournit alors un signal numérique de sortie correspondant aux deux bits OUT2 et OUT2-1. En outre, le convertisseur 1 ne comprend alors pas le circuit 984, mais comprend à la place un circuit arithmétique configuré pour fournir le signal de sortie TDCOUT à partir des bits OUT1, OUT2 et OUT2-1. Ce circuit arithmétique est configuré pour simultanément mettre en œuvre la dérivée mathématique du signal OUT2 à partir des bits OUT2 et OUT2-1, et la somme de cette dérivée avec le bit OUT1.

On a considéré, en relation avec la figure 9, le cas où le signal S1 ne correspond pas au signal clkref reçu par une boucle à verrouillage de phase du type de celle de la figure 4. En se basant sur les descriptions faites en relation avec les figures 4 à 9, la personne du métier sera en mesure d'adapter la description faite en relation avec la figure 9 aux cas où :
- la durée Dmax des impulsions P1 est différente d'une période Tclk du signal clk et est, par exemple, égale à deux périodes Tclk du signal clk, et/ou
- le signal S1 correspond au signal clkref d'une boucle à verrouillage de phase du type de celle décrite en relation avec la figure 4, et/ou
- le signal S2 correspond au signal clk d'une boucle à verrouillage de phase du type de celle décrite en relation avec la figure 4 ou est obtenu par division entière, par exemple égale à deux, de la fréquence de ce signal clk, et/ou
- le convertisseur 1 est d'ordre supérieur à 2.

Par exemple, la personne du métier sera en mesure de modifier, sur la base de la description faite en relation avec les figures 5 à 8, le convertisseur 1 de la figure 9 pour le mettre en œuvre dans une boucle à verrouillage de phase du type de celle décrite en relation avec la figure 4.

Par exemple, lorsque le convertisseur 1 d'ordre 2 décrit en relation avec la figure 9 est mis en œuvre dans une boucle à verrouillage de phase du type de celle de la figure 4, et que le premier étage STAGE1 du convertisseur 1 d'ordre 2 correspond au convertisseur 1 d'ordre 1 décrit en relation avec la figure 5, la fréquence du signal clk étant alors au moins 4 fois plus grande que celle du signal S1. En variante, lorsque le convertisseur 1 d'ordre 2 décrit en relation avec la figure 9 est mis en œuvre dans une boucle à verrouillage de phase du type de celle de la figure 4, et que le premier étage STAGE1 du convertisseur 1 d'ordre 2 correspond au convertisseur 1 d'ordre 1 décrit en relation avec la figure 7, la fréquence du signal clk étant alors au moins 5 fois plus grande que celle du signal S1.

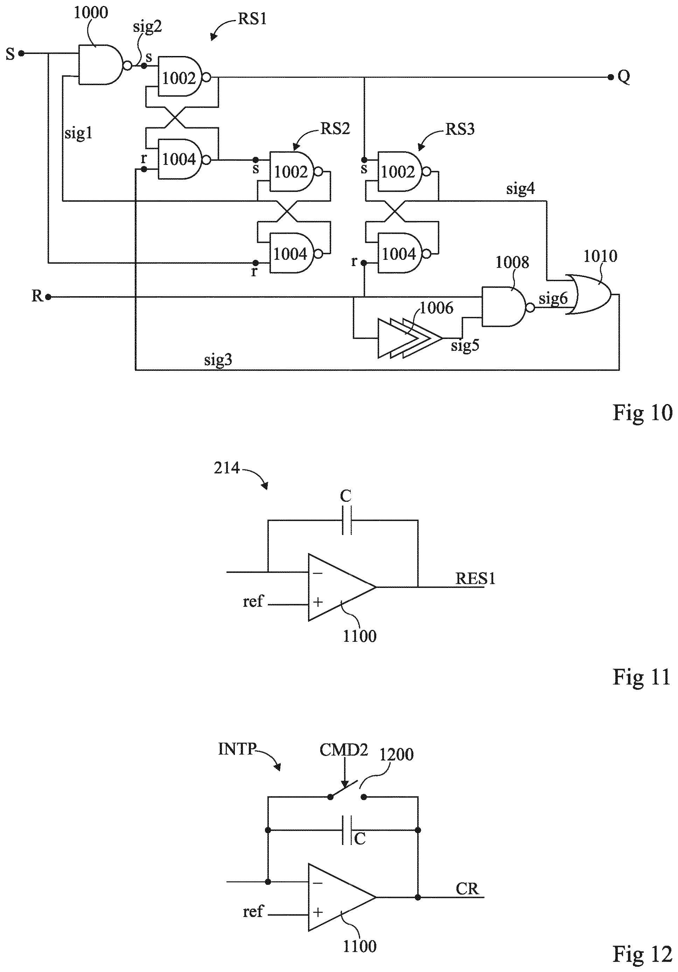

La figure 10 illustre un exemple de mise en œuvre d'une partie du convertisseur 1 des figures précédentes. Plus particulièrement, la figure 10 illustre un exemple de mode de réalisation d'une bascule RS, par exemple la bascule RS du circuit C1, configurée pour tenir compte d'éventuels problèmes de métastabilité.

Dans cet exemple, la bascule RS est active sur fronts montants, ou, dit autrement, les entrées S et R de la bascule sont toutes les deux sensibles aux fronts montants des signaux qu'elles reçoivent.

La bascule comprend une porte NON ET ("NAND" en anglais) 1000 ayant une entrée connectée à l'entrée S et une entrée configurée pour recevoir un signal sig1. La sortie de la porte 1000 fournit un signal sig2.

La bascule comprend trois ensembles identiques RS1, RS2 et RS3 de deux portes NON ET 1002 et 1004. Chaque ensemble RS1, RS2 et RS3 comprend une entrée s connectée à une première entrée de sa porte 1002 et une entrée r connectée à une première entrée de sa porte 1004, la sortie de la porte 1002 étant connectée à une deuxième entrée de la porte 1004, et la sortie de la porte 1004 étant connectée à une deuxième entrée de la porte 1002.

L'entrée s de l'ensemble RS1 reçoit le signal sig2, et la sortie de la porte 1002 de l'ensemble RS1 constitue la sortie Q de la bascule RS de la figure 10. En outre, l'entrée r de l'ensemble RS1 reçoit un signal sig3.

L'entrée s de l'ensemble RS2 est connectée à la sortie de la porte 1004 de l'ensemble RS1, l'entrée r de l'ensemble RS2 est connectée à l'entrée S de la bascule RS de la figure 10, et la sortie de la porte 1004 de l'ensemble RS2 fournit le signal sig1.

L'entrée s de l'ensemble RS3 est connectée à la sortie de la porte 1002 de l'ensemble RS1, donc à la sortie Q de la bascule, l'entrée r de l'ensemble RS3 est connectée à l'entrée R de la bascule, et la sortie de la porte 1002 de l'ensemble RS3 fournit un signal sig4.

La bascule comprend en outre un circuit 1006, par exemple une chaine d'inverseurs en série, ayant une entrée connectée à l'entrée R de la bascule et une sortie fournissant un signal sig5. Le circuit 1006 est configuré pour retarder le signal reçu par l'entrée R d'une durée DT, le signal sig5 correspondant à ce signal retardé.

La bascule RS de la figure 10 comprend en outre une porte NON-ET 1008 ayant une entrée connectée à l'entrée R de la bascule, une autre entrée connectée à la sortie du circuit 1006 de manière à recevoir le signal sig5, et une sortie configurée pour fournir un signal sig6.

La bascule comprend en outre une porte OU ("OR" en anglais) ayant une entrée recevant le signal sig6, une entrée recevant le signal sig4 et une sortie fournissant le signal sig3.

Si on suppose qu'initialement la sortie Q est au niveau bas, le signal sig1 est au niveau haut. Grâce à cela, l'arrivée d'un niveau haut sur l'entrée S peut se propager à travers la porte 1000, qui fournit alors un niveau bas du signal sig2. L'ensemble RS1 commute alors la sortie Q au niveau haut. Le signal sig3 est initialement au niveau haut et sa commutation au niveau bas permettra de rebasculer la sortie Q au niveau bas 0. Dans le même temps, comme le signal sig3 est encore au niveau haut, l'entrée s de l'ensemble RS2 reçoit un niveau bas. Comme l'entrée r de l'ensemble RS2 est connectée à l'entrée S qui est passée au niveau haut, le signal sig1 commute au niveau bas, ce qui entraine que le signal sig2 commute au niveau haut. Ce mécanisme rend la bascule sensible uniquement aux fronts montants de S, la sortie Q restant mémorisée au niveau haut tant que le signal sig3 n'est pas passé par le niveau bas. Pour activer à nouveau la sortie Q, il faudra que l'entrée S commute au niveau bas et que le signal sig1 commute au niveau haut. En parallèle, l'ensemble RS3 fournit initialement le signal sig4 au niveau haut, du fait que la sortie Q est initialement au niveau bas. Quand le signal Q commute au niveau haut, il existe deux possibilités. Soit l'entrée R était déjà au niveau haut à ce moment-là et le signal sig4 reste au niveau haut, soit l'entrée R était au niveau bas et dans ce cas le signal sig4 commute au niveau bas. Ce mécanisme est important car le front montant de l'entrée R peut avoir lieu à tout instant par rapport au front montant de la sortie Q. En particulier, la sortie Q et l'entrée R peuvent présenter un front montant au même instant. Dans ce cas, l'ensemble RS3 entre dans un état métastable, dans lequel le signal sig4 met plus de temps à "choisir" entre un niveau bas et un niveau haut. Dans le cas le plus défavorable, le signal sig4 ne va commuter que grâce au bruit électronique présent dans le circuit et donc à un instant aléatoire. Comme l'écart type de ce bruit peut être connu, il est possible de connaitre le temps maximum Tmax qui peut être nécessaire au signal sig4 pour commuter. Le but du circuit 1006 et du signal sig6 est de laisser du temps à l'ensemble RS3 pour sortir de la métastabilité et commuter. La porte 1008 permet de mettre le signal sig6 au niveau bas uniquement quand l'entrée R est au niveau haut depuis une durée au moins égale à Tmax. Comme le signal sig3 est le résultat du OU logique entre les signaux sig4 et sig6, si sig6 a fini par commuter au niveau bas, il faudra attendre la durée DT pour que le signal sig3 puis la sortie Q passent au niveau bas. S'il peut être garanti que la durée DT est supérieure à la durée Tmax, le signal sig3 ne va pas subir le retard aléatoire dû à la métastabilité mais uniquement un retard constant égal à DT. De cette façon le front descendant de l'impulsion sur la sortie Q peut éviter d'être entachée d'une gigue ("jitter" en anglais) dommageable au résultat.

A titre d'exemple, lorsque la bascule 200 du circuit C1 est mise en œuvre de la façon décrite en relation avec la figure 10, la durée Dmax des impulsions P1 est augmentée de DT, et cette durée DT doit être compensée par les impulsions P2, en augmentant la durée des impulsions P2 d'une durée DT2. Il en résulte que DT*A1=DT2*A2, donc que DT2=(DT*A1)/A2. Par exemple, dans le cas où A1=2*A2, alors DT2=2*DT.

Bien entendu, bien que la bascule décrite en relation avec la figure 10 soit tout particulièrement adaptée à une mise en œuvre dans le circuit C1 du convertisseur 1, une bascule plus simple, par exemple une bascule RS similaire à l'un des ensembles RS1, RS2 et RS3, mais n'adressant pas les problèmes de métastabilité peut être utilisée pour mettre en œuvre le circuit C1.

La figure 11 illustre un exemple de mise en œuvre d'une autre partie du convertisseur 1 des figures précédentes. Plus particulièrement, la figure 11 illustre un exemple de mise en œuvre du circuit 214, étant entendu que le circuit 912 peut être mis en œuvre de la même façon.

Dans cet exemple, le circuit 214 comprend un amplificateur opérationnel 1100 ayant une première entrée, dans cet exemple l'entrée inverseuse -, configurée pour recevoir les impulsions à intégrer, une deuxième entrée, dans cet exemple l'entrée non inverseuse +, recevant un potentiel quelconque, de préférence le potentiel ref comme cela est illustré en figure 11, et une sortie fournissant le résultat de l'intégration, à savoir le signal RES1 pour le circuit 214. Une capacité C est connectée entre la sortie de l'amplificateur 1100 et l'entrée non inverseuse - de l'amplificateur 1100.

Dans cet exemple, le circuit 214 reçoit les impulsions à intégrer sur l'entrée inverseuse - de l'amplificateur 1100. Il en résulte qu'une impulsion positive, respectivement négative, provoque une diminution, respectivement une augmentation, du signal RES1 avec une pente proportionnelle à l'amplitude de l'impulsion.

En pratique, le circuit 214 de la figure 11 est un filtre passe bas de fréquence de coupure f0 ayant le comportement d'un intégrateur pur pour les fréquences plus grandes que la fréquence f0. La fréquence f0 dépend notamment de la valeur de la capacité C. Ainsi, il sera toujours possible de choisir la fréquence f0 suffisamment faible devant la fréquence du signal clk pour que le circuit 214 se comporte, dans le convertisseur 1, comme un intégrateur pur.

On notera que si l'entrée inverseuse - de l'amplificateur 1100 est laissée en état haute impédance, aucun courant ne circule dans la capacité C et, comme les courants de fuite sont faibles, la sortie de l'amplificateur mémorise son état, c'est-à-dire qu'elle reste constante et égale à la valeur qu'elle avait au moment où l'entrée inverseuse - est passée en état haute impédance.

La figure 12 illustre un exemple de mise en œuvre d'encore une autre partie du convertisseur 1 des figures précédentes. Plus particulièrement, la figure 11 illustre un exemple de mise en œuvre du circuits INTP.

Le circuit INTP diffère du circuit 214 en ce que la sortie de l'amplificateur 1100 fournit le signal CR et en ce qu'un interrupteur 1200 est connecté en parallèle de la capacité C. L'interrupteur 1200 est configuré, lorsqu'il est à l'état passant, pour réinitialiser au niveau de l'entrée non inverseuse +, de préférence le niveau ref comme cela est illustré en figure 12, la sortie de l'amplificateur 1100. L'interrupteur 1200 est, par exemple, commandé par le signal CMD2 et est alors configuré pour être passant à chaque impulsion CMD2.

Dans cet exemple, comme en figure 10, le circuit INTP reçoit les impulsions à intégrer sur l'entrée inverseuse de l'amplificateur 1100. Il en résulte qu'une impulsion positive, respectivement négative, provoque une diminution, respectivement une augmentation, du signal CR avec une pente proportionnelle à l'amplitude de l'impulsion.

La mise en œuvre des circuits 214, 912 et INTP ne se limite pas aux exemples décrits en relation avec les figures 11 et 12, et la personne du métier pourra utiliser des intégrateurs usuels pour mettre en œuvre les circuits INT, INT2 et INTP. En particulier, la personne du métier est en mesure de prévoir des intégrateurs dont le signal de sortie augmente, respectivement diminue, lorsqu'ils reçoivent une impulsion à intégrer positive, respectivement négative, comme cela a été décrit à titre d'exemple en relation avec les figures 3, 6 et 8.

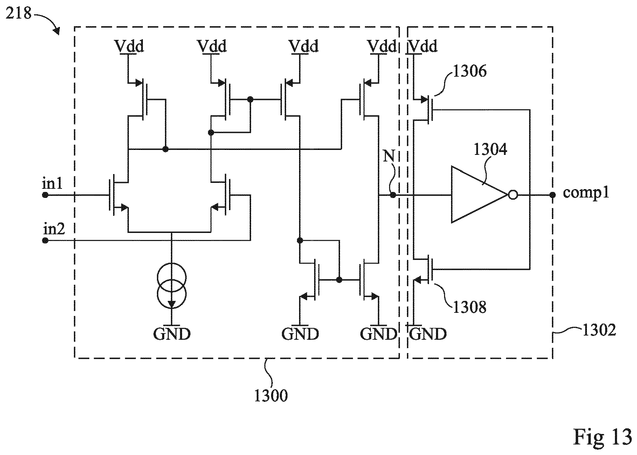

La figure 13 illustre un exemple de mise en œuvre d'encore une autre partie du convertisseur 1 des figures précédentes. Plus particulièrement, la figure 13 illustre un exemple de mise en œuvre du circuit 218, étant entendu que le circuit 910 peut être mis en œuvre de la même façon. Dans cet exemple, le niveau d'alimentation bas du convertisseur 1, donc du comparateur 218 est la masse GND, et le niveau ref est égal à Vdd/2.

Dans cet exemple, le circuit 218 comprend un amplificateur différentiel classique 1300 (en pointillés en figure 13) ayant une entrée in1 inverseuse, une entrée in2 inverseuse, et une sortie N.

Dans cet exemple, le circuit 218 comprend en outre, connecté à la sortie N de l'amplificateur 1300, un étage 1302 comprenant un inverseur 1304 et deux transistors 1306 et 1308, respectivement à canal P et à canal N. L'inverseur 1304 a une entrée connectée à la sortie N de l'étage 1300 et une sortie fournissant le signal comp1 de sortie du circuit 218. Le transistor 1306 est connecté entre le noeud N et le potentiel Vdd, le transistor 1308 étant connecté entre le noeud N et le potentiel d'alimentation bas, ici la masse GND. Les transistors 1306 et 1308 sont commandés par la sortie de l'inverseur 1304, c'est-à-dire par la sortie du circuit 218.

Les transistors 1306 et 1308 mettent en œuvre une contre réaction positive de la sortie de l'inverseur 1304 sur la sortie N de l'étage 1300, qui permet d'accélérer la commutation du signal comp1. Cela permet d'obtenir un signal comp1 ayant des niveaux haut et bas bien distincts, même lorsque la valeur de l'entrée in1 est proche de celle de l'entrée in2.

Bien entendu, la mise en œuvre des circuits 218 et 910 ne se limite pas à l'exemple illustré en figure 13, et la personne du métier pourra utiliser d'autres comparateurs à seuils usuels pour mettre en œuvre les circuits C3 et C6. En particulier, la mise en œuvre des comparateurs à seuils ne se limite pas au cas où ref est égale à la moitié de la tension d'alimentation du comparateur.

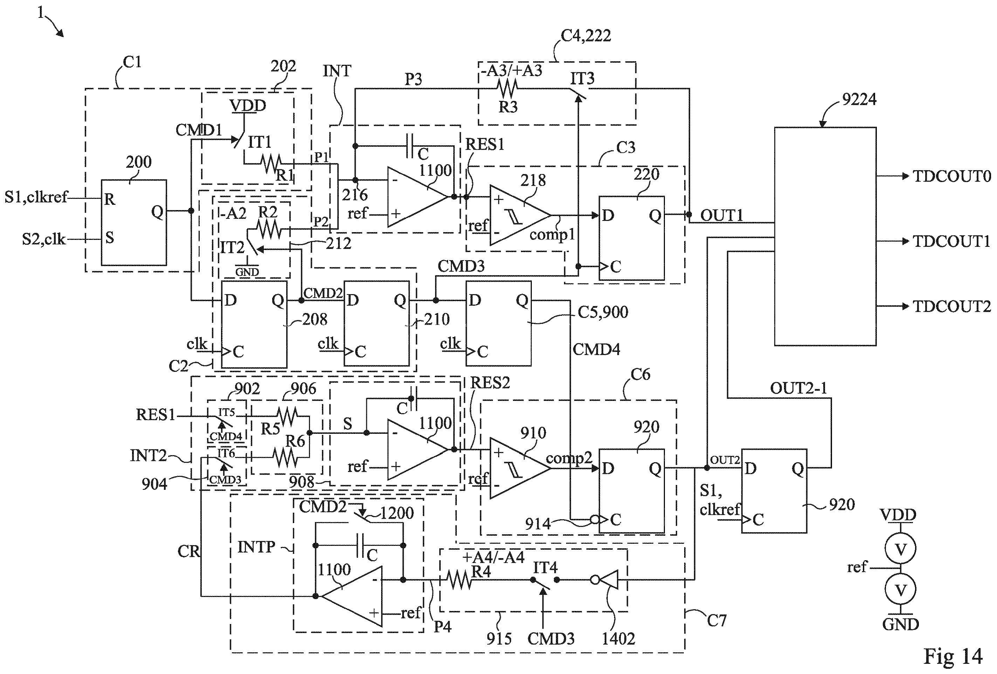

La figure 14 illustre un exemple détaillé de mise en œuvre du convertisseur 1 décrit en relation avec la figure 9. Dans cet exemple, l'étage STAGE1 correspond au convertisseur 1 décrit en relation avec la figure 5, c'est-à-dire que le signal S1 correspond au signal clkref et que le signal S2 correspond au signal clk. Dans cet exemple, K2=K3=1.

Dans cet exemple, le potentiel d'alimentation bas du convertisseur 1 est la masse GND, et le niveau ref est égal à Vdd/2. Toutefois, la personne du métier est en mesure d'adapter la description qui va suivre au cas où le potentiel d'alimentation bas est un potentiel Vss égal à -Vdd et où le niveau ref est la masse GND, et, plus généralement au cas où le niveau ref est différent de la moitié de la tension d'alimentation du convertisseur 1.

Dans cet exemple, le circuit C1, comme en figure 5 comprend la bascule 200 de type RS configurée pour fournir le signal CMD1. En outre, dans cet exemple, le circuit 202 du circuit C1 comprend un interrupteur IT1 en série avec une résistance R1, entre le potentiel d'alimentation haut Vdd et le noeud 216, l'interrupteur IT1 étant de préférence connecté au potentiel Vdd. L'interrupteur IT1 est commandé par le signal CMD1 de sorte à n'être passant que lors des impulsions CMD1. Ainsi, chaque impulsion CMD1 résulte en une impulsion positive P1 de courant sur le noeud 216, de niveau +A1. L'amplitude A1 des impulsions P1 est la différence entre les potentiels Vdd et ref divisée par la valeur de la résistance R1.

Dans cet exemple, le circuit C2 est mis en œuvre de la manière décrite en relation avec la figure 5. En outre, le circuit 212 du circuit C2 comprend, dans cet exemple, un interrupteur IT2 en série avec une résistance R2, entre le potentiel d'alimentation bas, ici la masse GND, et le noeud 216, l'interrupteur IT2 étant de préférence connecté au potentiel d'alimentation bas GND. L'interrupteur IT2 est commandé par le signal CMD2 de sorte à n'être passant que lors des impulsions CMD2. Ainsi, chaque impulsion CMD2 résulte en une impulsion négative P2 de courant sur le noeud 216, de niveau -A2. L'amplitude des impulsions P2 est déterminée par la différence entre les potentiels ref et GND divisée par la valeur de la résistance R2. Dans cet exemple où l'amplitude A1 des impulsions P1 est égale à deux fois l'amplitude A2 des impulsions P2, la résistance R2 a une valeur deux fois plus grande que celle de la résistance R1.

Dans cet exemple, le circuit INT est mis en œuvre de la manière décrite en relation avec la figure 11, et comprend donc un amplificateur 1100 et une capacité C. L'entrée inverseuse - de l'amplificateur 1100 du circuit INT est connectée au noeud 216, l'entrée non inverseuse + de l'amplificateur 1100 du circuit INT étant connectée au potentiel ref. Ainsi, dans cet exemple, le signal RES1 augmente, respectivement diminue, lorsque l'amplificateur 1100 du circuit INT reçoit une impulsion négative, respectivement positive, sur son entrée -.

Dans cet exemple, le circuit C3 est mis en œuvre de la manière décrite en relation avec la figure 5. A titre d'exemple, le circuit 218 est mis en œuvre de la manière décrite en relation avec la figure 13 et reçoit le niveau ref sur son entrée inverseuse (in1 en figure 13 et - en figure 14) et le signal RES1 sur son entrée non inverseuse (in2 en figure 13 et + en figure 14). Ainsi, dans cet exemple, le signal comp1 est à un niveau haut, respectivement bas, lorsque le signal RES1 est supérieur, respectivement inférieur, au niveau ref, et le bit OUT1 est mis à jour avec le niveau du signal comp1 à chaque début d'impulsion CMD3. Il en résulte que, par rapport au fonctionnement décrit en relation avec les chronogrammes des figures 3, 6 et 8, le sens de variation du signal RES1 en fonction de la polarité des impulsions que reçoit le circuit INT est inversé, ce qui provoque une inversion du bit OUT1.

Dans cet exemple, le circuit C4 (ou 222 ou bloc - A3/+A3) comprend un interrupteur IT3 et une résistance R3 en série entre la sortie du circuit C3 et le noeud 216. L'interrupteur IT3 est commandé par le signal CMD3 de sorte à n'être passant que lors des impulsions CMD3. Ainsi, chaque impulsion CMD3 résulte en une impulsion P3 sur le noeud 216, qui a un niveau négatif -A3 ou positif +A3 selon que la sortie du circuit C3 (bit OUT1) soit respectivement au niveau bas égal au potentiel d'alimentation bas ou au niveau haut égal au potentiel d'alimentation haut. Dans cet exemple, du fait que les variations du signal RES1 relativement à la polarité des impulsions sont inversés, et donc que l'état du bit OUT1 est inversé, par rapport au fonctionnement décrit en relation avec les figures 3, 6 et 8, la polarité des impulsions P3 relativement à l'état haut ou bas du signal OUT1 est également inversée par rapport à ce qui a été décrit en relation avec les figures 3, 6 et 8. Par ailleurs, l'amplitude A3 des impulsions P3 est déterminée par la moitié de la différence entre les potentiels Vdd et GND divisée par la valeur de la résistance R3. Dans cet exemple où l'amplitude A1 des impulsions P1 est égale à deux fois l'amplitude A3 des impulsions P3, la résistance R3 a une valeur deux fois plus grande que celle de la résistance R1.

Dans cet exemple, le circuit C5 est mis en œuvre de la façon décrite en relation avec la figure 9, c'est-à-dire par la bascule 900.

Dans cet exemple, le circuit C6 est mis en œuvre de la façon décrite en relation avec la figure 9. Le circuit 910 est par exemple mis en œuvre par un comparateur tel que décrit en relation avec la figure 13 ayant son entrée inverseuse (-en figure 14, in1 en figure 13) recevant le niveau ref, son entrée non inverseuse (+ en figure 14, in2 en figure 13) recevant le signal RES2 de sortie du circuit INT2, et sa sortie fournissant le signal comp2.

Dans cet exemple, le circuit C7 est mis en œuvre de la façon décrite en relation avec la figure 9.

Dans cet exemple, le circuit INTP est mis en œuvre de la façon décrite en relation avec la figure 12, l'entrée inverseuse - de l'amplificateur 1100 du circuit INTP recevant le potentiel ref et l'entrée non inverseuse + de cet amplificateur 1100 recevant les impulsions P4. L'interrupteur 1200 du circuit INTP est, par exemple, commandé par le signal CMD2, de sorte à être passant pendant chaque impulsion CMD2.

Dans cet exemple le circuit INT2 est mis en œuvre de la façon décrite en relation avec la figure 9. Plus particulièrement, le circuit 908 est mis en œuvre de la façon décrite en relation avec la figure 11, par un amplificateur opérationnel 1100 et une capacité C, l'entrée inverseuse - de l'amplificateur 1100 recevant le signal ref, l'entrée non inverseuse + de l'amplificateur 1100 recevant le signal S, et la sortie de l'amplificateur 1100 fournissant le signal RES2. En outre, le circuit 906 correspond, dans cet exemple, à deux résistances R5 et R6, de même valeur, connectée chacune entre une entrée respective du circuit 906 et l'entrée inverseuse - de l'amplificateur 1100 du circuit 908, le signal S étant disponible sur l'entrée inverseuse - de l'amplificateur 1100. Le circuit 902 correspond, dans cet exemple, à un interrupteur IT5 connecté entre la sortie du circuit INT et une entrée du circuit 906. L'interrupteur IT5 est commandé par les impulsions CMD4 de sorte à n'être passant que lors des impulsions CMD4. Ainsi, le signal RES1 n'est fourni en entrée du circuit 906 que lors de chaque impulsion CMD4. De manière similaire, dans cet exemple, le circuit 904 correspond à un interrupteur IT6 connecté entre la sortie du circuit C7 et une autre entrée du circuit 906. L'interrupteur IT6 est commandé par les impulsions CMD4 de sorte à n'être passant que lors des impulsions CMD4. Ainsi, le signal CR n'est fourni en entrée du circuit 906 que lors de chaque impulsion CMD4. Il en résulte que le signal S correspondant à la somme des signaux CR et RES1 n'est fourni en entrée du circuit 908, c'est-à-dire à l'entrée inverseuse - de l'amplificateur 1100 de ce circuit 908, que lors de chaque impulsion CMD4.

Dans cet exemple, le circuit 915 ou bloc +A4/-A4 comprend un interrupteur IT4, un inverseur 1402 et une résistance R4 en série entre la sortie du circuit C6 et le circuit INTP. L'interrupteur IT4 est commandé par le signal CMD3 de sorte à n'être passant que lors des impulsions CMD3. Ainsi, chaque impulsion CMD3 résulte en une impulsion P4 fournie au circuit INTP, qui a un niveau négatif -A4 lorsque le bit OUT2 est à l'état haut et un niveau positif +A4 lorsque le bit OUT2 est à l'état bas. L'amplitude A4 des impulsions P4 est déterminée par la moitié de la différence entre les potentiels Vdd et GND divisée par la valeur de la résistance R4. Dans cet exemple où l'amplitude A1 des impulsions P1 est égale à deux fois l'amplitude A4 des impulsions P4, la résistance R4 a une valeur deux fois plus grande que celle de la résistance R1.

Dans cet exemple, le signal RES2 augmente, respectivement diminue, lorsque que le circuit 908 reçoit une impulsion S négative, respectivement positive, le signal comp2 est à l'état binaire haut, respectivement bas, lorsque le signal RES2 est supérieur, respectivement inférieur, au niveau ref, le signal OUT2 est mis à jour avec l'état du signal comp2 à chaque fin d'impulsion CMD4, et le signal CR augmente, respectivement diminue, lorsque l'impulsion P4 reçue par le circuit INTP est négative, respectivement positive. Ainsi, la personne du métier comprend que, pour mettre en œuvre la contre réaction négative dans l'étage STAGE2 (non référencé en figure 14) selon l'exemple de la figure 14, les impulsions P4 doivent être négatives lorsque le bit OUT2 est à l'état binaire haut, et positives lorsque le bit OUT2 est à l'état binaire bas. La personne du métier est en mesure de modifier la polarité des impulsions P4 relativement à l'état binaire du bit OUT2 dans les cas où, par rapport à l'exemple de la figure 14, le signal RES2 augmente, respectivement diminue, lorsque les impulsions S sont positives, respectivement négatives, et/ou le signal comp2 est à l'état binaire haut, respectivement bas, lorsque le signal RES2 est inférieur, respectivement supérieur, au niveau ref, et/ou le bit OUT2 est mis à jour avec l'état binaire complémentaire du signal comp2 à chaque fin d'impulsion CMD4, et/ou le signal CR augmente, respectivement diminue, lorsque les impulsions P4 sont positives, respectivement négatives.

Dans cet exemple, le circuit DER et le circuit 984 décrits en relation avec la figure 9 sont en partie confondus, ou, dit autrement, la sortie de l'étage STAGE2 du convertisseur 1 de la figure 14 correspond aux deux bits OUT2 et OUT2-1. Plus exactement, le circuit 922 du circuit DER et le circuit 984 sont mis en œuvre par un circuit 9224 configuré pour recevoir les signaux OUT, OUT2 et OUT2-1 et pour fournir le signal TDCOUT, dans cet exemple codé en complément à 2 sur trois bits TDCOUT0, TDCOUT1 et TDCOUT2. Le circuit 9224 est un circuit logique numérique, mis en œuvre à partir de portes logiques combinatoires, par exemple à partir de portes OU EXCLUSIF ("XOR" en anglais) et/ou de portes inverseuses et/ou de portes ET ("AND" en anglais) et/ou de porte OU ("OR" en anglais), etc. En figure 14, le circuit 9224 est représenté sous la forme d'un bloc, sa mise en œuvre étant à la portée de la personne du métier.

Dans l'exemple détaillé de mise en œuvre illustré par la figure 14, le circuit 9224 est par exemple configuré pour fournir les bits TDCOUT0, TDCOUT1 et TDCOUT2 à partir des bits OUT1, OUT2 et OUT2-1 conformément au tableau Table 1 ci-dessous. Dans cet exemple, l'état binaire '1', respectivement '0', d'un bit correspond à un niveau haut, respectivement bas, de ce bit, et le bit TDCOUT2 représente le signe du signal TDCOUT qui correspond à la concaténation des bits TDCOUT2, TDCOUT1 et TDCOUT0.

**[Table 1]**

| OUT1 | OUT2 | OUT2-1 | TDCOUT2 | TDCOUT1 | TDCOUT0 | Valeur de TDCOUT |
|---|---|---|---|---|---|---|
| '1' | '0' | '0' | '0' | '0' | '0' | 0 |
| '0' | '0' | '0' | '0' | '0' | '1' | 1 |
| '1' | '1' | '0' | '0' | '0' | '1' | 1 |
| '0' | '1' | '0' | '0' | '1' | '0' | 2 |
| '1' | '0' | '1' | '1' | '1' | '1' | -1 |
| '0' | '0' | '1' | '0' | '0' | '0' | 0 |
| '1' | '1' | '1' | '0' | '0' | '0' | 0 |
| '0' | '1' | '1' | '0' | '0' | '1' | 1 |

Comme pour le convertisseur 1 d'ordre 2 décrit en relation avec la figure 9, en se basant sur les descriptions faites en relation avec les figures 1 à 9, la personne du métier sera en mesure d'adapter la description faite en relation avec la figure 14 aux cas où :
- la durée Dmax des impulsions P1 est différente d'une période Tclk du signal clk et est, par exemple, égale à deux périodes Tclk du signal clk, et/ou
- le convertisseur 1 n'est pas mis en œuvre dans une boucle à verrouillage de phase en tout numérique, et/ou
- le convertisseur 1 est d'ordre supérieur à 2.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

En particulier, la personne du métier est en mesure d'adapter la description faite précédemment au cas où toutes les polarités des impulsions sont inversées. Plus généralement, la personne du métier est en mesure d'inverser les états haut et bas de l'un quelconque des signaux binaires et/ou de l'une quelconque des impulsions CMD1, CMD2, CMD3 et CMD4 et/ou les signes des impulsions P1, P2, P3 et P4 en adaptant les circuits qui reçoivent ou fournissent ces signaux de sorte que les fonctionnalités mises en œuvre par ces circuits restent celles décrites dans la présente demande.

En outre, la personne du métier sera en mesure de prévoir d'autres exemples de valeurs pour les nombres K1, K2, K3 et K4 en adaptant les amplitudes A1, A2, A3 et A4 en fonction de la dynamique du convertisseur 1.

La personne du métier sera également en mesure de prévoir d'autres exemples de mise en œuvre des circuits décrits précédemment. Par exemple, les circuits C3 et C6 pourraient être chacun mis en œuvre uniquement par une bascule D dont la sortie Q est mise à un premier état binaire, respectivement un deuxième état binaire, si son entrée D est inférieure, respectivement supérieure, au niveau ref lorsque son entrée C reçoit un front auquel cette entrée C est sensible, la bascule mettant alors en œuvre simultanément une quantification binaire et la mémorisation de cette quantification.

Enfin, la mise en oeuvre pratique des modes de réalisation et variantes décrits est à la portée de la personne du métier à partir des indications fonctionnelles données ci-dessus.

## Revendications

1. Convertisseur temps numérique de type sigma-delta comprenant :
un premier circuit (C1) configuré pour fournir, à chaque front actif d'un premier signal (S1), une première impulsion (P1) de durée déterminée par un écart entre ledit front actif du premier signal (S1) et un front actif immédiatement successif d'un deuxième signal (S2) ;
un circuit intégrateur (INT) configuré, à chaque première impulsion (P1), pour intégrer :
- la première impulsion (P1),
- une deuxième impulsion (P2) débutant après la première impulsion (P1) et en synchronisme avec un signal d'horloge (clk), et
- une troisième impulsion (P3) débutant après la deuxième impulsion (P2) et en synchronisme avec le signal d'horloge (clk) ;
un deuxième circuit (C2) configuré pour générer, pour chaque première impulsion (P1), la deuxième impulsion correspondante (P2) ;
un troisième circuit (C3) configuré pour quantifier sur un bit (comp1) un signal de sortie (RES1) du circuit intégrateur (INT) et, au début de chaque troisième impulsion (P3), mémoriser sur un premier bit (OUT1) ladite quantification binaire ; et
un quatrième circuit (C4) configuré pour générer, pour chaque première impulsion (P1), la troisième impulsion (P3) correspondante à partir du premier bit (OUT1),
dans lequel le deuxième circuit (C2) est configuré pour recevoir le signal d'horloge (clk) et pour générer au moins un troisième signal (CMD3) configuré pour commander les mémorisations par le troisième circuit (C3) et les générations des troisièmes impulsions (P3) par le quatrième circuit (C4), et
dans lequel le premier circuit (C1) est configuré pour fournir un quatrième signal (CMD1) indiquant un début et une fin de chaque première impulsion (P1), le deuxième circuit (C2) étant configuré pour recevoir le quatrième signal (CMD1) et pour générer le troisième signal (CMD3) à partir du signal d'horloge (clk) et du quatrième signal (CMD1) .

2. Convertisseur selon la revendication 1, dans lequel :
les premier (C1) et deuxième (C2) circuits sont configurés pour que les deuxièmes impulsions (P2) placent un zéro de conversion du convertisseur (1) au milieu de la dynamique du convertisseur (1) ; et
le quatrième circuit (C4) est configuré pour que l'intégration de chaque troisième impulsion (P3) mette en oeuvre une soustraction de la quantification binaire mémorisée (OUT1) au début de ladite troisième impulsion (P3).

3. Convertisseur selon la revendication 1 ou 2, dans lequel :
les premier (C1) et deuxième (C2) circuits sont configurés pour que chaque deuxième impulsion (P2) provoque, sur le signal de sortie (RES1) du circuit intégrateur (INT), une variation d'amplitude identique et de signe opposé à une variation d'amplitude que provoquerait une première impulsion (P1) de durée déterminée par la moitié de la dynamique du convertisseur (1) ; et
le quatrième circuit (P4) est configuré pour que chaque troisième impulsion (P3) mette en œuvre une contre réaction négative sigma-delta.

4. Convertisseur selon l'une quelconque des revendications 1 à 3, dans lequel :
les premières, deuxièmes et troisièmes impulsions (P1, P2, P3) sont signées ;
les premier et deuxième circuits (C1, C2) sont configurés pour qu'un signe des deuxièmes impulsions (P2) soit opposé à un signe des premières impulsions (P1) et qu'une durée maximale des premières impulsions que le convertisseur (1) peut convertir multipliée par une amplitude des premières impulsions (P1) soit égale à deux fois une durée des deuxièmes impulsions (P2) multipliée par une amplitude des deuxièmes impulsions (P2) ; et
le quatrième circuit est configuré pour qu'un signe de chaque troisième impulsion (P3) soit déterminé par un état du premier bit (OUT) et qu'une amplitude des troisièmes impulsions (P3) multipliée par une durée des troisièmes impulsion soit égale à la durée des deuxièmes impulsions (P2) multipliée par l'amplitude des deuxièmes impulsions (P2) .

5. Convertisseur selon l'une quelconque des revendications 1 à 4, dans lequel les deuxièmes et troisièmes impulsions (P2, P3) ont chacune une durée multiple d'une période du signal d'horloge (clk), de préférence égale à une période du signal d'horloge (clk).

6. Convertisseur selon l'une quelconque des revendications 1 à 5, dans lequel une sortie (TDCOUT) dudit convertisseur (1) est au moins en partie déterminée par le premier bit (OUT1).

7. Convertisseur selon l'une quelconque des revendications 1 à 6, dans lequel le convertisseur (1) est du type sigma-delta à mise en forme du bruit à étage multiple, le convertisseur (1) comprenant un premier étage (STAGE1) comprenant le circuit intégrateur (INT) et les premier, deuxième, troisième et quatrième circuits (C1, C2, C3, C4), et un deuxième étage (STAGE2) configuré pour recevoir un signal de sortie (RES1) du circuit intégrateur (INT) du premier étage (STAGE1) et pour fournir un signal numérique de sortie (NUM ; OUT2, OUT2-1) du deuxième étage à partir du signal de sortie (RES1) du circuit intégrateur (INT) du premier étage, une sortie (TDCOUT) dudit convertisseur (1) étant déterminée au moins en partie par le premier bit (OUT1) et le signal numérique de sortie (NUM ; OUT2, OUT2-1) du deuxième étage (STAGE2).

8. Convertisseur selon la revendication 7, dans lequel le deuxième étage (STAGE2) est configuré pour :
générer, après chaque troisième impulsion (P3), une quatrième impulsion (CMD4) débutant en synchronisme avec le signal d'horloge (clk) ;
intégrer, pendant chaque quatrième impulsion (CMD4), une somme (S) du signal de sortie (RES1) du circuit intégrateur (INT) du premier étage (STAGE1) et d'un signal de contre réaction (CR), quantifier sur un bit (comp2) un résultat de ladite intégration et mémoriser sur un deuxième bit (OUT2) ladite quantification binaire (comp2) à la fin de la quatrième impulsion (CMD4) ;
générer, pendant chaque troisième impulsion (P3), une cinquième impulsion (P4) à partir du deuxième bit (OUT2), et le signal de contre réaction (CR) en intégrant ladite cinquième impulsion (P4) ; et
mémoriser le deuxième bit (OUT2) sur un troisième bit (OUT2-1) à chaque front actif du premier signal (S1), le signal numérique de sortie (NUM ; OUT2, OUT2-1) du deuxième étage (STAGE2) étant généré à partir des deuxième et troisième bits ou correspondant aux deuxième et troisième bits.

9. Convertisseur selon la revendication 7, dans lequel le deuxième étage (STAGE2) comprend :
un cinquième circuit (C5) configuré pour générer, après chaque troisième impulsion, une quatrième impulsion (CMD4) débutant en synchronisme avec le signal d'horloge (clk) ;
un circuit intégrateur (INT2) configuré pour intégrer, pendant chaque quatrième impulsion (CMD4), une somme (S) du signal de sortie (RES1) du circuit intégrateur (INT) du premier étage (STAGE1) et d'un signal de contre réaction (CR) ;
un sixième circuit (C6) configuré pour quantifier sur un bit (comp2) une sortie (RES2) du circuit intégrateur (INT2) du deuxième étage (STAGE2) et mémoriser ladite quantification binaire (comp2) sur un deuxième bit (OUT2), à la fin de chaque quatrième impulsion (CMD4) ;
un septième circuit (C7) configuré, à chaque troisième impulsion (P3), pour fournir ledit signal de contre réaction (CR) en intégrant, pendant ladite troisième impulsion (P3), une cinquième impulsion (P4) déterminée à partir du deuxième bit (OUT2) ; et
un circuit configuré pour mémoriser le deuxième bit (OUT2) sur un troisième bit (OUT2-1) à chaque front actif du premier signal (S1), le signal numérique de sortie (NUM ;
OUT2, OUT2-1) du deuxième étage (STAGE2) étant généré à partir des deuxième et troisième bits ou correspondant aux deuxième et troisième bits.

10. Convertisseur selon l'une quelconque des revendications 1 à 9, dans lequel le convertisseur (1) comprend une première entrée configurée pour recevoir le premier signal (S1) et une deuxième entrée configurée pour recevoir le signal d'horloge (clk), et dans lequel :
le deuxième signal (S2) et le signal d'horloge (clk) sont confondus, ou
le convertisseur (1) comprend un circuit (700) diviseur de fréquence, de préférence par deux, configuré pour recevoir le signal d'horloge (clk) et pour fournir le deuxième signal (S2).

11. Boucle à verrouillage de phase en tout numérique (4) configurée pour recevoir un signal (clkref) à une première fréquence et pour fournir un signal (clk) à une deuxième fréquence égale à N/D fois la première fréquence, avec N et D deux valeurs positives, la boucle à verrouillage de phase (4) comprenant un convertisseur (1) selon la revendication 10, la première entrée du convertisseur étant configurée pour recevoir le signal (clkref) à la première fréquence et la deuxième entrée du convertisseur étant configurée pour recevoir le signal (clk) à la deuxième fréquence.

12. Boucle à verrouillage de phase (4) selon la revendication 11 comprenant :
un circuit (accN) configuré pour fournir un premier signal numérique (accNOUT) incrémenté de la valeur N à la première fréquence ;
un circuit (accD, reg) configuré pour fournir un deuxième signal numérique (accDOUT) incrémenté de la valeur D à la deuxième fréquence et un troisième signal numérique (accDOUT') correspondant à une mémorisation du deuxième signal numérique (accDOUT) cadencée à la première fréquence ;
un filtre numérique (402) configuré pour recevoir une soustraction d'une sortie (TDCOUT) du convertisseur (1) et du troisième signal numérique (accDOUT') au premier signal numérique (accNOUT) et pour commander un oscillateur (404) configuré pour fournir le signal (clk) à la deuxième fréquence,
dans laquelle le deuxième signal (S2) du convertisseur (1) est confondu avec le signal (clk) à la deuxième fréquence.

13. Boucle à verrouillage de phase selon la revendication 11 comprenant :
soit un circuit (accN) configuré pour fournir un premier signal numérique (accNOUT) incrémenté de la valeur N à la première fréquence, et un circuit configuré pour fournir un deuxième signal numérique incrémenté de la valeur D/2 à la deuxième fréquence, avec D pair, soit un circuit configuré pour fournir un premier signal numérique incrémenté de la valeur 2N à la première fréquence et un circuit (accD) configuré pour fournir un deuxième signal numérique (accDOUT) incrémenté de la valeur D à la deuxième fréquence ;
un circuit (reg) configuré pour fournir un troisième signal numérique (accDOUT') correspondant à une mémorisation du deuxième signal numérique (accDOUT) cadencée par le deuxième signal (S2) du convertisseur ;
un filtre numérique (402) configuré pour recevoir une soustraction d'une sortie (TDCOUT) du convertisseur (1) et du troisième signal numérique (accDOUT') au premier signal numérique (accNOUT) et pour commander un oscillateur (404) configuré pour fournir le signal (clk) à la deuxième fréquence,
dans laquelle le deuxième signal (S2) du convertisseur (1) est obtenu en divisant par deux la fréquence du signal (clk) à la deuxième fréquence.

## Patentansprüche

1. Zeit-zu-Digital-Wandler vom Sigma-Delta-Typ, aufweisend:
eine erste Schaltung (C1), die konfiguriert ist zum Liefern, bei jeder aktiven Flanke eines ersten Signals (S1), eines ersten Impulses (P1) mit einer Dauer, die durch ein Intervall zwischen der aktiven Flanke des ersten Signals (S1) und einer unmittelbar nachfolgenden aktiven Flanke eines zweiten Signals (S2) bestimmt ist;
eine Integratorschaltung (INT), die konfiguriert ist, bei jedem ersten Impuls (P1), zum Integrieren:
- des ersten Impulses (P1),
- eines zweiten Impulses (P2), der nach dem ersten Impuls (P1) und synchron mit einem Taktsignal (clk) beginnt, und
- eines dritten Impulses (P3), der nach dem zweiten Impuls (P2) und synchron mit dem Taktsignal (clk) beginnt;
eine zweite Schaltung (C2), die konfiguriert ist zum Erzeugen, für jeden ersten Impuls (P1), des entsprechenden zweiten Impulses (P2);
eine dritte Schaltung (C3), die konfiguriert ist zum Quantisieren über ein Bit (comp1) eines Ausgangssignals (RES1) der Integratorschaltung (INT) und, zu Beginn jedes dritten Impulses, zum Speichern über ein erstes Bit (OUT1) der binären Quantisierung; und
eine vierte Schaltung (C4), die konfiguriert ist zum Erzeugen, für jeden ersten Impuls (P1), des entsprechenden dritten Impulses (P3) basierend auf dem ersten Bit (OUT1),
wobei die zweite Schaltung (C2) konfiguriert ist zum Empfangen des Taktsignals (clk) und zum Erzeugen wenigstens eines dritten Signals (CMD3), das konfiguriert ist zum Steuern der Speicherungen durch die dritte Schaltung (C3) und der Erzeugungen der dritten Impulse (P3) durch die vierte Schaltung (C4), und
wobei die erste Schaltung (C1) konfiguriert ist zum Liefern eines vierten Signals (CMD1), das einen Beginn und ein Ende jedes ersten Impulses (P1) anzeigt, wobei die zweite Schaltung (C2) konfiguriert ist zum Empfangen des vierten Signals (CMD1) und zum Erzeugen des dritten Signals (CMD3) basierend auf dem Taktsignal (clk) und basierend auf dem vierten Signal (CMD1).

2. Wandler nach Anspruch 1, wobei:
die erste (C1) und die zweite (C2) Schaltung so konfiguriert sind, dass die zweiten Impulse (P2) einen Wandlungsnullpunkt des Wandlers (1) in die Mitte des Dynamikbereichs des Wandlers (1) legen; und
die vierte Schaltung (C4) so konfiguriert ist, dass die Integration jedes dritten Impulses (P3) eine Subtraktion der binären Quantisierung (OUT1) implementiert, die zu Beginn des dritten Impulses (P3) gespeichert wurde.

3. Wandler nach Anspruch 1 oder 2, wobei:
die erste (C1) und die zweite (C2) Schaltung so konfiguriert sind, dass jeder zweite Impuls (P2) am Ausgangssignal (RES1) der Integratorschaltung (INT) eine Variation mit identischer Amplitude und mit einem Vorzeichen entgegengesetzt zu einer Amplitudenvariation verursacht, die durch einen ersten Impuls (P1) mit einer Dauer verursacht würde, die durch die Hälfte des Dynamikbereichs des Wandlers (1) bestimmt ist; und
die vierte Schaltung (P4) so konfiguriert ist, dass jeder dritte Impuls (P3) eine negative Sigma-Delta-Rückkopplung implementiert.

4. Wandler nach einem der Ansprüche 1 bis 3, wobei:
die ersten, zweiten und dritten Impulse (P1, P2, P3) vorzeichenbehaftet sind;
die erste und die zweite Schaltung (C1, C2) so konfiguriert sind, dass ein Vorzeichen der zweiten Impulse (P2) entgegengesetzt zu einem Vorzeichen der ersten Impulse (P1) ist und dass eine maximale Dauer der ersten Impulse, die der Wandler (1) wandeln kann, multipliziert mit einer Amplitude der ersten Impulse (P1) gleich dem Zweifachen einer Dauer der zweiten Impulse (P2) multipliziert mit einer Amplitude der zweiten Impulse (P2) ist; und
die vierte Schaltung so konfiguriert ist, dass ein Vorzeichen jedes dritten Impulses (P3) durch einen Zustand des ersten Bits (OUT) bestimmt wird und dass eine Amplitude der dritten Impulse (P3) multipliziert mit einer Dauer der dritten Impulse gleich der Dauer der zweiten Impulse (P2) multipliziert mit der Amplitude der zweiten Impulse (P2) ist.

5. Wandler nach einem der Ansprüche 1 bis 4, wobei die zweiten und dritten Impulse (P2, P3) jeweils eine Dauer aufweisen, die ein Vielfaches einer Periode des Taktsignals (clk) ist, vorzugsweise gleich einer Periode des Taktsignals (clk).

6. Wandler nach einem der Ansprüche 1 bis 5, wobei ein Ausgang (TDCOUT) des Wandlers (1) wenigstens teilweise durch das erste Bit (OUT1) bestimmt wird.

7. Wandler nach einem der Ansprüche 1 bis 6, wobei der Wandler (1) vom Sigma-Delta-Mehrstufen-Rauschformungstyp ist, wobei der Wandler (1) eine erste Stufe (STAGE1) aufweist, die die Integratorschaltung (INT) und die erste, zweite, dritte und vierte Schaltung (C1, C2, C3, C4) aufweist, und eine zweite Stufe (STAGE2), die konfiguriert ist zum Empfangen eines Ausgangssignals (RES1) der Integratorschaltung (INT) der ersten Stufe (STAGE1) und zum Liefern eines digitalen Ausgangssignals (NUM; OUT2, OUT2-1) der zweiten Stufe basierend auf dem Ausgangssignal (RES1) der Integratorschaltung (INT) der ersten Stufe, wobei ein Ausgang (TDCOUT) des Wandlers (1) wenigstens teilweise durch das erste Bit (OUT1) und das digitale Ausgangssignal (NUM; OUT2, OUT2-1) der zweiten Stufe (STAGE2) bestimmt wird.

8. Wandler nach Anspruch 7, wobei die zweite Stufe (STAGE2) konfiguriert ist zum:
Erzeugen, nach jedem dritten Impuls (P3), eines vierten Impulses (CMD4), der synchron mit dem Taktsignal (clk) beginnt;
Integrieren, während jedes vierten Impulses (CMD4), einer Summe (S) des Ausgangssignals (RES1) der Integratorschaltung (INT) der ersten Stufe (STAGE1) und eines Rückkopplungssignals (CR);
Quantisieren über ein Bit (comp2) eines Ergebnisses der Integration und zum Speichern der binären Quantisierung (comp2) am Ende des vierten Impulses (CMD4) über ein zweites Bit (OUT2);
Erzeugen, während jedes dritten Impulses (P3), eines fünften Impulses (P4) basierend auf dem zweiten Bit (OUT2) und des Rückkopplungssignals (CR) durch Integrieren des fünften Impulses (P4); und
Speichern des zweiten Bits (OUT2) über ein drittes Bit (OUT2-1) bei jeder aktiven Flanke des ersten Signals (S1), wobei das digitale Ausgangssignal (NUM; OUT2, OUT2-1) der zweiten Stufe (STAGE2) basierend auf dem zweiten und dritten Bit erzeugt wird oder dem zweiten und dritten Bit entspricht.

9. Wandler nach Anspruch 7, wobei die zweite Stufe (STAGE2) aufweist:
eine fünfte Schaltung (C5), die konfiguriert ist zum Erzeugen, nach jedem dritten Impuls, eines vierten Impulses (CMD4), der synchron mit dem Taktsignal (clk) beginnt;
eine Integratorschaltung (INT2), die konfiguriert ist zum Integrieren, während jedes vierten Impulses (CMD4), einer Summe (S) des Ausgangssignals (RES1) der Integratorschaltung (INT) der ersten Stufe (STAGE1) und eines Rückkopplungssignals (CR);
eine sechste Schaltung (C6), die konfiguriert ist zum Quantisieren über ein Bit (comp2) eines Ausgangs (RES2) der Integratorschaltung (INT2) der zweiten Stufe (STAGE2) und zum Speichern der binären Quantisierung (comp2) über ein zweites Bit (OUT2), am Ende jedes vierten Impulses (CMD4);
eine siebte Schaltung (C7), die konfiguriert ist, bei jedem dritten Impuls (P3), zum Liefern des Rückkopplungssignals (CR) durch Integrieren, während des dritten Impulses (P3), eines fünften Impulses (P4), der basierend auf dem zweiten Bit (OUT2) bestimmt wird; und
eine Schaltung, die konfiguriert ist zum Speichern des zweiten Bits (OUT2) über ein drittes Bit (OUT2-1) bei jeder aktiven Flanke des ersten Signals (S1), wobei das digitale Ausgangssignal (NUM; OUT2, OUT2-1) der zweiten Stufe (STAGE2) basierend auf dem zweiten und dritten Bit erzeugt wird oder dem zweiten und dritten Bit entspricht.

10. Wandler nach einem der Ansprüche 1 bis 9, wobei der Wandler (1) einen ersten Eingang aufweist, der konfiguriert ist zum Empfangen des ersten Signals (S1), und einen zweiten Eingang, der konfiguriert ist zum Empfangen des Taktsignals (clk), und wobei:
das zweite Signal (S2) und das Taktsignal (clk) ein und dasselbe sind, oder
der Wandler (1) eine Schaltung (700) zum Teilen der Frequenz, vorzugsweise durch zwei, aufweist, die konfiguriert ist zum Empfangen des Taktsignals (clk) und zum Liefern des zweiten Signals (S2).

11. Volldigitale Phasenregelschleife (4), die konfiguriert ist zum Empfangen eines Signals (clkref) bei einer ersten Frequenz und zum Liefern eines Signals (clk) bei einer zweiten Frequenz gleich N/D-mal der ersten Frequenz, wobei N und D zwei positive Werte sind, wobei die Phasenregelschleife (4) einen Wandler (1) nach Anspruch 10 aufweist, wobei der erste Eingang des Wandlers konfiguriert ist zum Empfangen des Signals (clkref) bei der ersten Frequenz und der zweite Eingang des Wandlers konfiguriert ist zum Empfangen des Signals (clk) bei der zweiten Frequenz.

12. Phasenregelschleife (4) nach Anspruch 11, aufweisend eine Schaltung (accN), die konfiguriert ist zum Liefern eines ersten digitalen Signals (accNOUT), das bei der ersten Frequenz um Wert N inkrementiert wird;
eine Schaltung (accD, reg), die konfiguriert ist zum Liefern eines zweiten digitalen Signals (accDOUT), das bei der zweiten Frequenz um Wert D inkrementiert wird, und eines dritten digitalen Signals (accDOUT'), das einer Speicherung des zweiten digitalen Signals (accDOUT) entspricht, die bei der ersten Frequenz getaktet wird;
ein digitales Filter (402), das konfiguriert ist zum Empfangen einer Subtraktion eines Ausgangs (TDCOUT) des Wandlers (1) und des dritten digitalen Signals (accDOUT') vom ersten digitalen Signal (accNOUT) und zum Steuern eines Oszillators (404), der konfiguriert ist zum Liefern des Signals (clk) bei der zweiten Frequenz,
wobei das zweite Signal (S2) des Wandlers (1) ein und dasselbe mit dem Signal (clk) bei der zweiten Frequenz ist.

13. Phasenregelschleife nach Anspruch 11, aufweisend
entweder eine Schaltung (accN), die konfiguriert ist zum Liefern eines ersten digitalen Signals (accNOUT), das bei der ersten Frequenz um Wert N inkrementiert wird, und eine Schaltung, die konfiguriert ist zum Liefern eines zweiten digitalen Signals, das bei der zweiten Frequenz um Wert D/2 inkrementiert wird, wobei D gerade ist, oder eine Schaltung, die konfiguriert ist zum Liefern eines ersten digitalen Signals, das bei der ersten Frequenz um Wert 2N inkrementiert wird, und eine Schaltung (accD), die konfiguriert ist zum Liefern eines zweiten digitalen Signals (accDOUT), das bei der zweiten Frequenz um Wert D inkrementiert wird;
eine Schaltung (reg), die konfiguriert ist zum Liefern eines dritten digitalen Signals (accDOUT'), das einer Speicherung des zweiten digitalen Signals (accDOUT) entspricht, die durch das zweite Signal (S2) des Wandlers getaktet wird;
ein digitales Filter (402), das konfiguriert ist zum Empfangen einer Subtraktion eines Ausgangs (TDCOUT) des Wandlers (1) und des dritten digitalen Signals (accDOUT') vom ersten digitalen Signal (accNOUT) und zum Steuern eines Oszillators (404), der konfiguriert ist zum Liefern des Signals (clk) bei der zweiten Frequenz,
wobei das zweite Signal (S2) des Wandlers (1) durch Teilen der Frequenz des Signals (clk) bei der zweiten Frequenz durch zwei erhalten wird.

## Claims

1. Time-to-digital converter of sigma-delta type comprising:
a first circuit (C1) configured to supply, at each active edge of a first signal (S1), a first pulse (P1) of duration determined by an interval between said active edge of the first signal (S1) and an immediately successive active edge of a second signal (S2);
an integrator circuit (INT) configured, at each first pulse (P1), to integrate:
- the first pulse (P1),
- a second pulse (P2) starting after the first pulse (P1) and in synchronism with a clock signal (clk), and
- a third pulse (P3) starting after the second pulse (P2) and in synchronism with the clock signal (clk);
a second circuit (C2) configured to generate, for each first pulse (P1), the corresponding second pulse (P2);
a third circuit (C3) configured to quantize over one bit (comp1) an output signal (RES1) of the integrator circuit (INT) and, at the beginning of each third pulse, store over a first bit (OUT1) said binary quantization; and
a fourth circuit (C4) configured to generate, for each first pulse (P1), the third corresponding pulse (P3) based on the first bit (OUT1),
wherein the second circuit (C2) is configured to receive the clock signal (clk) and to generate at least one third signal (CMD3) configured to control the storages by the third circuit (C3) and the generations of the third pulses (P3) by the fourth circuit (C4), and
wherein the first circuit (C1) is configured to supply a fourth signal (CMD1) indicating a beginning and an end of each first pulse (P1), the second circuit (C2) being configured to receive the fourth signal (CMD1) and to generate the third signal (CMD3) based on the clock signal (clk) and based on the fourth signal (CMD1).

2. Converter according to claim 1, wherein:
the first (C1) and second (C2) circuits are configured so that the second pulses (P2) place a conversion zero of the converter (1) in the middle of the dynamic range of the converter (1) ; and
the fourth circuit (C4) is configured so that the integration of each third pulse (P3) implements a subtraction of the binary quantization (OUT1) stored at the beginning of said third pulse (P3).

3. Converter according to claim 1 or 2, wherein:
the first (C1) and second (C2) circuits are configured so that each second pulse (P2) causes, on the output signal (RES1) of the integrator circuit (INT), a variation of identical amplitude and of a sign opposite to an amplitude variation that would be caused by a first pulse (P1) of duration determined by half the dynamic range of the converter (1); and
the fourth circuit (P4) is configured so that each third pulses (P3) implements a negative sigma-delta feedback.

4. Converter according to any of claims 1 to 3, wherein:
the first, second, and third pulses (P1, P2, P3) are signed;
the first and second circuits (C1, C2) are configured so that a sign of the second pulses (P2) is opposite to a sign of the first pulses (P1) and that a maximum duration of the first pulses that the converter (1) can convert multiplied by an amplitude of the first pulses (P1) is equal to twice a duration of the second pulses (P2) multiplied by an amplitude of the second pulses (P2); and the fourth circuit is configured so that a sign of each third pulse (P3) is determined by a state of the first bit (OUT) and that an amplitude of the third pulses (P3) multiplied by a duration of the third pulses is equal to the duration of the second pulses (P2) multiplied by the amplitude of the second pulses (P2).

5. Converter according to any of claims 1 to 4, wherein the second and third pulses (P2, P3) each have a duration which is a multiple of a period of the clock signal (clk), preferably equal to one period of the clock signal (clk).

6. Converter according to any of claims 1 to 5, wherein an output (TDCOUT) of said converter (1) is at least partly determined by the first bit (OUT1).

7. Converter according to any of claims 1 to 6, wherein the converter (1) is of sigma-delta multi-stage noise shaping type, the converter (1) comprising a first stage (STAGE1) comprising the integrator circuit (INT) and the first, second, third, and fourth circuits (C1, C2, C3, C4), and a second stage (STAGE2) configured to receive an output signal (RES1) of the integrator circuit (INT) of the first stage (STAGE1) and to supply a digital output signal (NUM; OUT2, OUT2-1) of the second stage based on the output signal (RES1) of the integrator circuit (INT) of the first stage, an output (TDCOUT) of said converter (1) being at least partly determined by the first bit (OUT1) and the output digital signal (NUM; OUT2, OUT2-1) of the second stage (STAGE2).

8. Converter according to claim 7, wherein the second stage (STAGE2) is configured to:
generate, after each third pulse (P3), a fourth pulse (CMD4) starting in synchronism with the clock signal (clk) ;
integrate, during each fourth pulse (CMD4), a sum (S) of the output signal (RES1) of the integrator circuit (INT) of the first stage (STAGE1) and of a feedback signal (CR), quantize over one bit (comp2) a result of said integration and store over a second bit (OUT2) said binary quantization (comp2) at the end of the fourth pulse (CMD4);
generate, during each third pulse (P3), a fifth pulse (P4) from based on the second bit (OUT2), and the feedback signal (CR) by integrating said fifth pulse (P4); and
store the second bit (OUT2) over a third bit (OUT2-1) at each active edge of the first signal (S1), the digital output signal (NUM; OUT2, OUT2-1) of the second stage (STAGE2) being generated based on the second and third bits or corresponding to the second and third bits.

9. Converter according to claim 7, wherein the second stage (STAGE2) comprises:
a fifth circuit (C5) configured to generate, after each third pulse, a fourth pulse (CMD4) starting in synchronism with the clock signal (clk);
an integrator circuit (INT2) configured to integrate, during each fourth pulse (CMD4), a sum (S) of the output signal (RES1) of the integrator circuit (INT) of the first stage (STAGE1) and of a feedback signal (CR);
a sixth circuit (C6) configured to quantize over one bit (comp2) an output (RES2) of the integrator circuit (INT2) of the second stage (STAGE2) and to store said binary quantization (comp2) over a second bit (OUT2), at the end of each fourth pulse (CMD4);
a seventh circuit (C7) configured, at each third pulse (P3), to supply said feedback signal (CR) by integrating, during said third pulse (P3), a fifth pulse (P4) determined based on the second bit (OUT2); and
a circuit configured to store the second bit (OUT2) over a third bit (OUT2-1) at each active edge of the first signal (S1), the digital output signal (NUM; OUT2, OUT2-1) of the second stage (STAGE2) being generated based on the second and third bits or corresponding to the second and third bits.

10. Converter according to any of claims 1 to 9, wherein the converter (1) comprises a first input configured to receive the first signal (S1) and a second input configured to receive the clock signal (clk), and wherein:
the second signal (S2) and the clock signal (clk) are one and the same, or
the converter (1) comprises a circuit (700) for dividing the frequency, preferably by two, configured to receive the clock signal (clk) and to supply the second signal (S2).

11. All digital phase locked loop (4) configured to receive a signal (clkref) at a first frequency and to supply a signal (clk) at a second frequency equal to N/D times the first frequency, N and D being two positive values, the phase-locked loop (4) comprising a converter (1) according to claim 10, the first input of the converter being configured to receive the signal (clkref) at the first frequency and the second input of the converter being configured to receive the signal (clk) at the second frequency.

12. Phase-locked loop (4) according to claim 11 comprising
a circuit (accN) configured to supply a first digital signal (accNOUT) incremented by value N at the first frequency;
a circuit (accD, reg) configured to supply a second digital signal (accDOUT) incremented by value D at the second frequency and a third digital signal (accDOUT') corresponding to a storage of the second digital signal (accDOUT) clocked at the first frequency;
a digital filter (402) configured to receive a subtraction of an output (TDCOUT) of the converter (1) and of the third digital signal (accDOUT') to the first digital signal (accNOUT) and to control an oscillator (404) configured to supply the signal (clk) at the second frequency,
wherein the second signal (S2) of the converter (1) is on and the same with the signal (clk) at the second frequency.

13. Phase-locked loop according to claim 11 comprising either a circuit (accN) configured to supply a first digital signal (accNOUT) incremented by value N at the first frequency, and a circuit configured to supply a second digital signal incremented by value D/2 at the second frequency, D being even, or a circuit configured to supply a first digital signal incremented by value 2N at the first frequency and a circuit (accD) configured to supply a second digital signal (accDOUT) incremented by value D at the second frequency;
a circuit (reg) configured to supply a third digital signal (accDOUT') corresponding to a storage of the second digital signal (accDOUT) clocked by the second signal (S2) of the converter;
a digital filter (402) configured to receive a subtraction of an output (TDCOUT) of the converter (1) and of the third digital signal (accDOUT') to the first digital signal (accNOUT) and to control an oscillator (404) configured to supply the signal (clk) at the second frequency,
wherein the second signal (S2) of the converter (1) is obtained by dividing by two the frequency of the signal (clk) at the second frequency.
